# EUROPEAN PATENT APPLICATION

(11) **EP 4 610 329 A1**
(43) Date of publication of application: **03.09.2025**
(21) Application number: 25159295.2
(22) Date of filing: 21.02.2025
(51) Int. Cl.: C09K 11/02, C09K 11/68, H10H 20/851

(54) **OXIDE PHOSPHOR, LIGHT EMITTING DEVICE, AND METHOD FOR PRODUCING OXIDE PHOSPHOR**

(30) Priority: 27.02.2024 JP 2024027260; 08.08.2024 JP 2024131746
(71) Applicant: NICHIA CORPORATION, Anan-shi, Tokushima 774-8601 (JP)
(72) Inventor: MURAZAKI, Yoshinori, Anan-shi, Tokushima, 774-8601 (JP)
(74) Representative: Vossius & Partner Patentanwälte Rechtsanwälte mbB

(57) **Abstract**

An oxide phosphor includes phosphor particles containing a host crystal containing Ga and oxygen and an activating element, and a first compound particle disposed on at a surface(s) of the phosphor particles, the at least one first compound particle containing an oxide particle containing a first element selected from the group consisting of Group 4 elements, Group 5 elements, Group 14 elements, and Group 15 elements.

## Description

### CROSS-REFERENCE TO RELATED PATENT APPLICATION

This application claims priority to Japanese Patent Application No. 2024-131746, filed on August 8, 2024, and Japanese Patent Application No. 2024-027260, filed on February 27, 2024, the entire disclosures of which are hereby incorporated by references in their entirety.

### BACKGROUND

### Technical Field

The present disclosure relates to an oxide phosphor, a light emitting device, and a method for producing an oxide phosphor.

### Description of Related Art

Light emitting devices having light emission intensity in a wavelength range from red light to near-infrared light are desired for use in, for example, infrared cameras, infrared communication, light sources for plant growth and cultivation, vein authentication, which is a type of biometric authentication, food component analyzers for non-destructive measurement of sugar content and other parameters in agricultural products or food such as fruits and vegetables, and analyzers for non-destructive measurement of foreign substances in pharmaceutical products. Light emitting devices that emit light in the wavelength range from red light to near-infrared light as well as in a wavelength range of visible light are also desired.

Examples of such light emitting devices include a light emitting device in which a light emitting diode (LED), and a phosphor are combined.

Examples of the phosphor to be combined in the light emitting device include a phosphor having a light emission spectrum with a large light emission intensity in the wavelength range from red light to near-infrared light (hereinafter, also referred to as "near-infrared light emitting phosphor").

As the near-infrared light emitting phosphor, Japanese Translation of PCT International Application Publication No. 2020-528486 discloses a phosphor having a light emission peak wavelength that is 680 nm or more and 760 nm or less and having a composition represented by, for example, CaYAlO₄:Mn⁴⁺.

There has also been a demand for a near-infrared light emitting phosphor having a light emission spectrum with an even wider full width at half maximum and with a light emission peak wavelength in an even longer wavelength range to be suitable for the various applications described above.

### SUMMARY

One object of the present disclosure is to provide an oxide phosphor having a light emission peak wavelength in a wavelength range from red light to near-infrared light and having a high light emission intensity, a light emitting device, and a method for producing the oxide phosphor.

According to a first aspect of the present disclosure, an oxide phosphor contains phosphor particles containing a host crystal containing Ga and oxygen and an activating element, and at least one first compound particle disposed on at least one of surfaces of the phosphor particles, the at least one first compound particle comprising an oxide particle comprising at least one first element selected from the group consisting of Group 4 elements, Group 5 elements, Group 14 elements, and Group 15 elements.

According to a second aspect of the present disclosure, a light emitting device includes the oxide phosphor, and a light emitting element configured to emit light having a light emission peak wavelength of 365 nm or more and 650 nm or less. The oxide phosphor is to be irradiated with the light emitted from the light emitting element.

According to a third aspect of the present disclosure, a method for producing an oxide phosphor includes: providing a raw material mixture containing a compound containing Ga and a compound containing Cr that serves as an activating element; providing a first flux containing an oxide containing at least one first element selected from the group consisting of Group 4 elements, Group 5 elements, Group 14 elements, and Group 15 elements; mixing the raw material mixture and the first flux to obtain a mixture; and heat-treating the mixture to obtain an oxide phosphor, the oxide phosphor comprising phosphor particles, and at least one first compound particle containing the first element and disposed on at least one of surfaces of the phosphor particles.

According to a fourth aspect of the present disclosure, a method for producing an oxide phosphor includes: providing a raw material mixture containing a compound containing Ga and a compound containing Cr that serves as an activating element; providing a first flux containing an oxide containing at least one first element selected from the group consisting of Group 4 elements, Group 5 elements, Group 14 elements, and Group 15 elements; providing a second flux containing a compound containing at least one second element selected from the group consisting of alkali metal elements and alkaline earth metal elements; mixing the raw material mixture, the first flux, and the second flux to obtain a mixture; and heat-treating the mixture to obtain an oxide phosphor, the oxide phosphor comprising: phosphor particles, at least one first compound particle containing the first element and disposed on at least one surfaces of the phosphor particles, and at least one second compound particle containing the second element and disposed on at least one surfaces of the phosphor particles.

The present disclosure allows for providing an oxide phosphor having a light emission peak wavelength in a wavelength range from red light to near-infrared light and having a high light emission intensity, and a light emitting device and a method for producing an oxide phosphor using the same.

### BRIEF DESCRIPTION OF THE DRAWINGS

FIG. 1 is a schematic cross-sectional view showing an exemplary light emitting device according to a first embodiment of the present disclosure.
FIG. 2 is a schematic cross-sectional view showing another exemplary light emitting device according to the first embodiment of the present disclosure.
FIG. 3 is a schematic plan view showing an exemplary light emitting device according to a second embodiment of the present disclosure.
FIG. 4 is a schematic cross-sectional view showing an exemplary light emitting device according to the second embodiment of the present disclosure.
FIG. 5 is a graph showing light emission spectra of the oxide phosphors according to Examples 1 and 2 and Comparative Example 1.
FIG. 6 is a graph showing light emission spectra of the oxide phosphors according to Examples 3 to 5.
FIG. 7 is a graph showing light emission spectra of the oxide phosphors according to Examples 6 to 8.
FIG. 8 is a graph showing light emission spectra of the oxide phosphors according to Examples 9 and 10.
FIG. 9 is a graph showing light emission spectra of the oxide phosphors according to Examples 11 and 12.
FIG. 10 is an SEM micrograph of the oxide phosphor according to Example 1.
FIG. 11 is an SEM micrograph of the surface of the oxide phosphor according to Example 4.
FIG. 12 is an SEM micrograph, as obtained by EDX analysis of the surface of the oxide phosphor according to Example 4, showing the distribution of a first element (Nb) contained in oxide particles, which are first compound particles.
FIG. 13 is an SEM micrograph, as obtained by EDX analysis of the surface of the oxide phosphor according to Example 4, showing the distribution of a second element (Na) contained in second compound particles.
FIG. 14 is an SEM micrograph of the oxide phosphor according to Comparative Example 1.
FIG. 15 shows an X-ray diffraction pattern of the oxide phosphor according to Example 12 and powder X-ray diffraction patterns showing the crystal structures of β-Ga₂O₃, Na₁₃Nb₃₅O₉₄, and Na(NbO₃).
FIG. 16 is a graph showing light emission spectra of the oxide phosphors according to Examples 13 to 15.
FIG. 17 is a graph showing light emission spectra of the oxide phosphors according to Examples 16 to 18.
FIG. 18 is a graph showing light emission spectra of the oxide phosphors according to Examples 19 and 20.
FIG. 19 is a graph showing light emission spectra of the oxide phosphors according to Examples 21 to 24.
FIG. 20 is a graph showing light emission spectra of the oxide phosphors according to Examples 25 to 28.
FIG. 21 is a graph showing light emission spectra of the oxide phosphors according to Examples 29 to 31 and Comparative Example 2.
FIG. 22 is a graph showing light emission spectra of the oxide phosphors according to Example 32 and Comparative Example 3.
FIG. 23 is a graph showing light emission spectra of the oxide phosphors according to Example 33 and Comparative Example 4.
FIG. 24 is a graph showing light emission spectra of the oxide phosphors according to Example 34 and Comparative Example 5.
FIG. 25 is a graph showing light emission spectra of the oxide phosphors according to Example 35 and Comparative Example 6.
FIG. 26 is a graph showing light emission spectra of the oxide phosphors according to Example 36 and Comparative Example 7.

### DETAILED DESCRIPTION

The oxide phosphor according to the present disclosure, and the light emitting device and method for producing an oxide phosphor using the same are described below. The embodiments described below are intended to give a concrete form to the technical idea of the present disclosure, and the present disclosure is not limited to the following oxide phosphor, light emitting device, and method for producing an oxide phosphor. For visible light, the relationship between color names and chromaticity coordinates, and the relationship between wavelength ranges of light and color names of monochromatic light are in accordance with Japanese Industrial Standard (JIS) Z8110.

Light emitting devices using a phosphor are required to emit light in an appropriate wavelength range according to a visual object or conditions of use. For example, in the medical field, there may be a need to easily obtain information inside a living body. The living body includes light absorbers such as water, hemoglobin, and melanin. For example, hemoglobin has a high light absorptance in a visible light wavelength range of less than 650 nm. With a light emitting device that emits light in the visible light wavelength range, the light in the visible light wavelength range is less easily transmitted through the living body, which makes it difficult to obtain information inside the living body. If it is possible to irradiate light in a wavelength range where absorption and scattering of light in living tissues are reduced, it becomes easier to obtain information deep inside the living body. Therefore, there is a need for a light emitting device that can emit light in a wavelength range referred to as a "biological window" where light easily transmits through the living body. The "biological window" may be referred to as a "first biological window" in a wavelength range of approximately 650 nm to approximately 950 nm, may be referred to as a "second biological window" in a wavelength range of approximately 1,000 nm to approximately 1,350 nm, and may be referred to as a "third biological window" in a wavelength range of approximately 1,500 nm to approximately 1,800 nm. For example, if the increase or decrease of oxygen concentration in the blood in the living body can be measured by measuring the increase or decrease of light absorption due to hemoglobin that binds to oxygen, the information inside the living body can be easily obtained by irradiation with the light emitted from the light emitting device. If the information deep inside the living body can be obtained by irradiation with the light emitted from the phosphor and the light emitting element instead of irradiating X-rays or others, it is possible to obtain the information inside the living body more safely. Therefore, the phosphor used in the light emitting device may be required to have a light emission peak wavelength in a wavelength range from red light to near-infrared light. The phosphor used in the light emitting device may be required to have a light emission peak wavelength that is 680 nm or more and 1,000 nm or less, preferably 700 nm or more and 1,000 nm or less, or a light emission peak wavelength that is 1,100 nm or more and 1,400 nm or less, upon irradiation with excitation light emitted from a light emitting element having a light emission peak wavelength that is 365 nm or more and 650 nm or less. Recently, there is a need for a light emitting device that emits light in a wavelength range of red light to near-infrared light, which allows for more clearly visualizing deep inside the living body and is highly safe. When a light emitting device including a light emitting element and a phosphor includes a phosphor having a high light emitting intensity that can emit light with a high output power, detection capability can be improved, making it easier to obtain information inside the living body.

In the agricultural and food fields, there is a need for non-destructive sugar content meters for non-destructively measuring the sugar content of agricultural products and fruits and vegetables, as well as measuring instruments (such as the Taste Analyzer (registered trademark)) that can non-destructively measure the taste of food such as rice. Near-infrared spectroscopy may be used as a non-destructive method for measuring internal quality such as sugar content, acidity, ripeness, and internal damage of fruits and vegetables, and the outer-layer quality appearing on the skin surface of fruits and vegetables or in the outer layer near the skin surface, such as abnormal drying. In the near-infrared spectroscopy, fruits and vegetables are irradiated with light in the near-infrared light wavelength range, and the transmitted light that is transmitted through the fruits and vegetables and the reflected light that is reflected by the fruits and vegetables are received, and the quality of the fruits and vegetables is measured by measuring the decrease in light intensity (light absorption). Light sources such as tungsten or xenon lamps are used in near-infrared spectroscopy analysis devices used in such food fields. The general rules for near-infrared spectrophotometric analysis in JIS K0134 state that near-infrared rays refers to a ray having a wavelength of 700 nm or more and 2,500 nm or less.

In the face of environmental changes such as climate change, it is also desirable to stably supply plants such as vegetables and to increase the production efficiency of plants. Plant factories that can be artificially controlled can stably supply safe vegetables to the market and are expected to be a next-generation industry. Such plant factories require a light emitting device that emits light capable of promoting the growth of plants. Reactions of plants to light can be grouped into photosynthesis and photomorphogenesis. Photosynthesis is a reaction that uses light energy to decompose water, generate oxygen, and fix carbon dioxide to organic materials, which is a necessary reaction for the growth of plants. Photomorphogenesis is a morphogenetic reaction that uses light as a signal for seed germination, differentiation (germ formation, leaf formation), movement (pore opening and closing, chloroplast movement), and photorefraction. In the photomorphogenesis reaction, it has been found that light with the wavelength of 690 nm or more and 800 nm or less affects the photoreceptors of plants. Therefore, light emitting devices used in plant factories may be required to be capable of emitting light in the wavelength range that affects plant photoreceptors (chlorophyll a, chlorophyll b, carotenoids, phytochromes, cryptochromes, and phototropins) and promotes the growth of plants.

For use in the light emitting device using a light emitting element such as a light emitting diode (LED) or laser diode (LD) configured to emit light in a range of purple to blue as an excitation light source, the above-mentioned near-infrared light emitting phosphor is also required to have a high light emission intensity so as to enable light emission suitable for the application and to enable more accurate detection.

Further, in some cases, light emitting devices that emit light in a wavelength range of 365 nm or more and less than 700 nm as well as light in the wavelength range of red light to near-infrared light is required. For example, there is a case in which it is necessary to emit light in the visible light wavelength range not only to obtain internal information on living bodies, fruits, and vegetables, but also to enhance the visibility of objects.

The oxide phosphor contains phosphor particles containing a host crystal, containing Ga and oxygen, and an activating element, and at least one first compound particle located on at least one of surfaces of the phosphor particles. The at least one first compound particles contain an oxide particle. The oxide particle contains at least one first element selected from the group consisting of Group 4 elements, Group 5 elements, Group 14 elements, and Group 15 elements.

To produce the oxide phosphor, a raw material mixture, which contains a compound containing an element to constitute a host crystal, containing Ga and oxygen, of the oxide phosphor and a compound containing an element to serve as an activating element of the oxide phosphor, is heat-treated together with a first flux containing an oxide containing at least one first element selected from the group consisting of Group 4 elements, Group 5 elements, Group 14 elements, and Group 15 elements, thus allowing for obtaining phosphor particles of an oxide phosphor having a large particle diameter and a high light emission intensity. As result of heat-treating the first flux together with the raw material mixture, first compound particles containing a first element or a film-shaped first compound containing a first element adhere to the surfaces of the resulting phosphor particles. The first compound particles containing a first element or the film-shaped first compound containing a first element adhered to the surfaces of the phosphor particles is also referred to as the first compound. The first compound particles contain oxide particles.

The first compound particles adhered to the surfaces of the phosphor particles have a particle diameter smaller than that of the phosphor particles. Whether or not the first compound particles are adhered to the surfaces of the phosphor particles can be confirmed, for example, by a scanning electron microscope (SEM) image obtained using an SEM. In addition, the oxide phosphor can be analyzed by an energy dispersive X-ray spectroscopy (EDX) to confirm the presence of the first compound particles on the surface of the phosphor particles. SEM or EDX analysis can be performed using, for example, an SEM-EDX system (e.g., model number SU8230, manufactured by Shimadzu Corporation, and a silicon drift detector, manufactured by HORIBA, Ltd.). It can also be confirmed from the image obtained by SEM or EDX analysis that the particle diameter of the first compound particles adhered to the surfaces of the phosphor particles is smaller than that of the phosphor particles. The presence of the film-shaped first compound adhered to the surfaces of the phosphor particles can also be confirmed by analyzing the resulting phosphor, for example, by the energy dispersive X-ray spectroscopy (EDX).

The amount of the first element contained in the first compound particles is preferably 0.05% by mass or more and 80% by mass or less relative to the total amount of the oxide phosphor being 100% by mass. The amount of the first element contained in the first compound particles is more preferably 0.05% by mass or more and 75% by mass or less, even more preferably 0.08% by mass or more and 70% by mass or less, and particularly preferably 0.10% by mass or more and 70% by mass or less; and may be 60% by mass or less, may be 50% by mass or less, may be 30% by mass or less, or may be 20% by mass or less, relative to the total amount of the oxide phosphor being 100% by mass. When the amount of the first element contained in the first compound particles is 0.05% by mass or more and 80% by mass or less relative to the total amount of the oxide phosphor being 100% by mass, the flux containing the first element facilitates crystal growth of the phosphor particles, which allows for obtaining phosphor particles of an oxide phosphor having a large particle diameter and a high light emission intensity. The amount (% by mass) of the first element contained in the first compound particles can be measured, for example, by totally dissolving phosphor particles (i.e., oxide phosphor) having first compound particles or a film-shaped first compound adhered to their surfaces in a mixed solution of sulfuric acid and nitric acid, and then determining the amount (% by mass) of the element derived from the first compound by inductively coupled plasma-atomic emission spectrometry (ICP-AES). If the same element as the element derived from the first compound is contained in the phosphor particles, the amount (% by mass) of the first element measured by ICP-AES also includes the amount (% by mass) of the same element as the first element contained in the oxide phosphor. Even if the same element as the first element derived from the first compound is contained in the phosphor particles, the flux containing the first element facilitates crystal growth of the phosphor particles as long as the amount (% by mass) of the first element is 0.05% by mass or more and 80% by mass or less relative to the total amount of the oxide phosphor being 100% by mass.

The at least one first element, which is at least one element selected from the group consisting of Group 4 elements, Group 5 elements, Group 14 elements, and Group 15 elements, is preferably at least one selected from the group consisting of Ti, Zr, Hf, V, Nb, Ta, Si, Ge, Sn, Pb, P, As, Sb, and Bi. It is more preferred that the first element is at least one selected from the group consisting of Ti, Zr, Hf, V, Nb, Ta, Si, Ge, Sn, P, and Bi. It is further preferred that the first element is at least one selected from the group consisting of Ti, Zr, Hf, Nb, Ta, Si, Ge, and P. As the at least one first element, one element or two or more elements of these may be used.

The first compound particles contain oxide particles, and the oxide particles are oxide particles containing a first element. The first compound particles may contain an oxide salt in which the element contained in the phosphor particles is bonded to an oxide. The oxide particles preferably contain an oxide contained in the first flux described below. When the first element is phosphorus (P), the first compound particles may be a phosphate. For example, the first compound particles may be ammonium phosphate ((NH₄)₃PO₄), diammonium hydrogen phosphate ((NH₄)₂HPO₄), or ammonium dihydrogen phosphate (NH₄H₂PO₄).

The oxide phosphor further contains second compound particles disposed on the surfaces of the phosphor particles, and the second compound particles preferably contain at least one second element selected from the group consisting of alkali metal elements and alkaline earth metal elements. The oxide phosphor preferably contains first compound particles, and second compound particles disposed on the surfaces of the phosphor particles.

To produce the oxide phosphor, a raw material mixture, containing a compound containing Ga and a compound containing an element serving as an activating element, is heat-treated together with a first flux, containing a compound containing a first element, and/or a second flux, containing a compound containing at least one second element selected from the group consisting of alkali metal elements and alkaline earth metal elements, thus allowing for obtaining phosphor particles of an oxide phosphor having a large particle diameter and a high light emission intensity. The first flux and/or the second flux is heat-treated together with the raw material mixture to form first compound particles and/or second compound particles, and the first compound particles and/or the second compound particles are adhered to the surfaces of the resulting phosphor particles. In one example, the first flux and/or the second flux is heat-treated together with the raw material mixture to form a film-shaped first compound, containing a first element, or a film-shaped second compound, containing a second element, and the film-shaped first compound or the film-shaped second compound is partially adhered to the surfaces of the phosphor particles. To produce the oxide phosphor, a raw material mixture containing a compound that contains Ga and a compound that contains an element to serve as an activating element is heat-treated together with a first flux, containing a compound containing a first element, and a second flux, containing a compound containing at least one second element selected from the group consisting of alkali metal elements and alkaline earth metal elements, thus allowing for obtaining phosphor particles having a larger particle diameter and a higher light emission intensity. The second compound particles containing a second element or the film-shaped second compound containing a second element adhered to the surfaces of the phosphor particles will also be referred to as the second compound.

The amount of the second element contained in the second compound particles is preferably 0.01% by mass or more and 80% by mass or less relative to the total amount of the oxide phosphor being 100% by mass. The amount of the second element contained in the second compound particles is more preferably 0.02% by mass or more and 60% by mass or less, even more preferably 0.03% by mass or more and 50% by mass or less, still more preferably 0.05% by mass or more and 40% by mass or less, and particularly preferably 0.10% by mass or more and 30% by mass or less; and may be 20% by mass or less, or may be 15% by mass or less, relative to the total amount of the oxide phosphor being 100% by mass. When the amount of the second element contained in the second compound particles is 0.01% by mass or more and 80% by mass or less relative to the total amount of the oxide phosphor being 100% by mass, the flux containing the second element facilitates crystal growth of the phosphor particles, thus allows for obtaining phosphor particles having a larger particle diameter and a higher light emission intensity. The amount (% by mass) of the second element contained in the second compound particles can be measured, for example, by totally dissolving phosphor particles (i.e., oxide phosphor) having second compound particles or a film-shaped second compound adhered to their surfaces in a mixed solution of sulfuric acid and nitric acid, and then determining the amount (% by mass) of the element derived from the second compound by inductively coupled plasma-atomic emission spectrometry (ICP-AES). If the same element as the second element derived from the second compound is contained in the phosphor particles, the amount (% by mass) of the second element measured by ICP-AES also includes the amount (% by mass) of the same element as the second element contained in the oxide phosphor. Even if the same element as the second element derived from the second compound is contained in the phosphor particles, the flux containing the second element facilitates crystal growth of the phosphor particles as long as the amount (% by mass) of the second element is 0.01% by mass or more and 80% by mass or less relative to the total amount of the oxide phosphor being 100% by mass.

In the oxide phosphor, when first compound particles or a film-shaped first compound and second compound particles or a film-shaped second compound are adhered to the surfaces of the phosphor particles, the amount of the first element is preferably larger than that of the second element. The structure in which the amount of the first element is larger than that of the second element indicates that the amount of the first flux is larger than that of the second flux in the first and second fluxes that are heat-treated together with the raw material mixture. When the amount of the first flux is larger than that of the second flux, the crystal growth is facilitated, phosphor particles of an oxide phosphor having a large particle diameter, and a high light emission intensity can be obtained. While it is not clear why containing a larger amount of the first flux than the amount of the second flux allows for facilitating the crystal growth, the oxide containing the first element contained in the first flux often has a higher melting point temperature than that of the compound containing the second element contained in the second flux. It is presumed that, when a flux containing a larger amount of the first flux than an amount of the second flux is heat-treated together with the raw material mixture, the liquid phase of the product obtained by reacting the compound used as the flux with a part of the raw material mixture is generated at a lower temperature, which is closer to the temperature of the heat treatment for obtaining phosphor particles. This is why the reaction of the compounds contained in the raw material mixture is promoted.

The second element is at least one selected from the group consisting of alkali metal elements and alkaline earth metal elements. It is preferred that the second element is at least one selected from the group consisting of Li, Na, K, Rb, Cs, Be, Mg, Ca, Sr, and Ba. It is more preferred that the second element is at least one selected from the group consisting of Li, Na, K, Rb, Mg, Ca, Sr, and Ba. It is even more preferred that the second element is at least one selected from the group consisting of Li, Na, K, Rb, Mg, Ca, Sr, and Ba, and it is further preferred that the second element is at least one selected from the group consisting of Li, Na, K, Rb, Sr, and Ba. The at least one second element may be one element or two or more elements of these.

A volume average particle diameter of the oxide phosphor at 50% cumulative in a volume-based particle size distribution, as measured by a laser diffraction particle size distribution measurement method, is preferably 10 µm or more and 50 µm or less. The laser diffraction particle size distribution measurement method is a method of measuring particle sizes by utilizing scattered laser light irradiated on particles without distinguishing between primary and secondary particles. The volume average particle diameter measured by the laser diffraction particle size distribution measurement method refers to a volume median diameter in which the cumulative frequency from the small diameter side is 50% in the volume-based particle size distribution. The oxide phosphor, by heat-treating together with the first flux, contains a first element and has a large volume average particle diameter of 10 µm or more and 50 µm or less. In the oxide phosphor, the volume average particle diameter in the volume-based particle size distribution measured by the laser diffraction particle size distribution measurement method is more preferably 15 µm or more and 48 µm or less, even **more preferably** 20 µm or more and 45 µm or less.

The phosphor particles of the oxide phosphor may contain a host crystal containing Ga and oxygen and an activating element, and preferably have a composition represented by the following formula (1), a composition represented by the following formula (2), or a composition represented by the following formula (3).

(Ga₁₋ᵥ₁M¹ᵥ₁)₂O₃:Crₓ₁ (1)

wherein M¹ represents at least one element selected from the group consisting of Al, In, and rare earth elements; and v1 and x1 satisfy 0 ≤ v1 ≤ 1.0 and 0.02 ≤ x1 ≤ 0.3.

(Mg₁₋ₜ₂M²ₜ₂)ᵤ₂(Ga₁₋ᵥ₂₋ₓ₂M³ᵥ₂)₂O_{w2}:Cr₂ₓ₂,M⁴_{y2} (2)

wherein M² represents at least one element selected from the group consisting of Ca, Sr, Ba, Ni, and Zn; M³ represents at least one element selected from the group consisting of B, Al, In, and Sc; M⁴ represents at least one element selected from the group consisting of Eu, Ce, Tb, Pr, Nd, Sm, Yb, Ho, Er, Tm, and Mn; t2, u2, v2, w2, x2, and y2 satisfy 0 ≤ t2 ≤ 0.8, 0.7 ≤ u2 ≤ 1.3, 0 ≤ v2 ≤ 0.8, 3.7 ≤ w2 ≤ 4.3, 0.01 < x2 ≤ 0.15, 0 ≤ y2 ≤ 0.2, and y2 < 2x2; and the "2x2" represents a product of 2 and the parameter x2.

(Li₁₋ₜ₃M⁵ₜ₃)ᵤ₃(Ga_{1-v3-x3-z3}M⁶ᵥ₃)₅O_{w3}:Cr₅ₓ₃,Ni_{y3},M⁷_{5z3} (3)

wherein M⁵ represents at least one element selected from the group consisting of Na, K, Rb, and Cs; M⁶ represents at least one element selected from the group consisting of B, Al, In, and rare earth elements; M⁷ represents at least one element selected from the group consisting of Si, Ge, Sn, Ti, Zr, Hf, Bi, V, Nb, and Ta; t3, u3, v3, w3, x3, y3, and z3 satisfy 0 ≤ t3 ≤ 1.0, 0.7 ≤ u3 ≤ 1.6, 0 ≤ v3 < 1.0, 7.85 ≤ w3 ≤ 11.5, 0.01 ≤ x3 ≤ 0.24, 0 ≤ y3 ≤ 0.5, 0.25 < 5x3+y3 ≤ 1.2, y3 < 5x3, and 0 ≤ z3 ≤ 0.1; the "5x3" represents a product of 5 and the parameter x3; and the "5z3" represents a product of 5 and the parameter z3.

The phosphor particles of the oxide phosphor may have a composition represented by the following formula (3').

(Li₁₋ₜ₃M⁵ₜ₃)ᵤ₃(Ga_{1-v3-x3-z3}M⁶ᵥ₃)₅O_{w3}:Cr₅ₓ₃,Ni_{y3} (3')

wherein M⁵ represents at least one element selected from the group consisting of Na, K, Rb, and Cs; M⁶ represents at least one element selected from the group consisting of B, Al, In, and rare earth elements; t3, u3, v3, w3, x3, and y3 satisfy 0 ≤ t3 ≤ 1.0, 0.7 ≤ u3 ≤ 1.6, 0 ≤ v3 < 1.0, 7.85 ≤ w3 ≤ 11.5, 0.01 ≤ x3 ≤ 0.24, 0 ≤ y3 ≤ 0.5, 0.25 < 5x3+y3 ≤ 1.2, and y3 < 5x3; and the "5x3" represents a product of 5 and the parameter x3.

In the phosphor particles having a composition represented by the formula (1), M¹ is preferably at least one element selected from the group consisting of Al, In, and rare earth elements, and may include two or more elements of these. The rare earth elements include Sc, Y, La, Ce, Pr, Nd, Pm, Sm, Eu, Gd, Tb, Dy, Ho, Er, Tm, Yb, and Lu. In the phosphor particles having a composition represented by the formula (1), the molar ratio of M¹ in 1 mol of the composition is represented by a product of 2 and the parameter v1, and the parameter v1 is preferably 0 or more and 1.0 or less (0 ≤ v1 ≤ 1.0), and may be 0.1 or more and 0.9 or less (0.1 ≤ v1 ≤ 0.9). In one example, the phosphor particles having a composition represented by the formula (1) do not contain M¹, and v1 is 0 (v1 = 0). In the phosphor particles having a composition represented by the formula (1), the parameter x1 representing the molar ratio of Cr serving as an activating element in 1 mol of the composition is preferably 0.02 or more and 0.3 or less (0.02 ≤ x1 ≤ 0.3), more preferably 0.02 or more and 0.2 or less (0.02 ≤ x1 ≤ 0.2), and even more preferably 0.03 or more and 0.1 or less (0.03 ≤ x1 ≤ 0.1).

It is preferable that the phosphor particles have a composition represented by the following formula (1-1) and the oxide phosphor exhibits, in a powder X-ray diffraction pattern measured using CuKα rays, a first peak P1, which is a peak top having an intensity that is the highest within a range of Bragg angles 2θ of 34° to 36°, inclusive, a second peak P2, which is a peak top having an intensity that is the lowest among intensities of peak tops within a range of Bragg angles 2θ of 31 ° to 33°, inclusive, and a peak intensity ratio (P1/P2) of the intensity of the first peak P1 to the intensity of the second peak P2 is 5 or more and 100 or less. When the peak intensity ratio (P1/P2) of the intensity of the first peak P1, which is a peak top having an intensity highest within a range of Bragg angles 2θ of 34° to 36°, inclusive, to the intensity of the second peak P2, which is a peak top having an intensity lowest among intensities of peak tops within a range of Bragg angles 2θ of 31° to 33°, inclusive is 5 or more and 100 or less, the phosphor particles having a composition represented by the following formula (1-1) has a large average particle diameter. The phosphor particles contains first compound particles containing a first element contained in a first flux, and crystals grow by the action of the first flux, so that a peak intensity ratio (P1/P2) of the first peak P1 to the second peak P2 in the powder X-ray diffraction pattern of the phosphor particles having a composition represented by the following formula (1-1) is 5 or more and 100 or less. In the powder X-ray diffraction pattern of the phosphor particles, the peak intensity ratio (P1/P2) of the first peak P1 to the second peak P2 may be 5 or more and 80 or less, or may be 5 or more and 60 or less.

Ga₂O₃:Crₓ₁ (1-1)

wherein x1 satisfies 0.02 ≤ x1 ≤ 0.3.

The phosphor particles having a composition represented by the formula (1), upon irradiation with excitation light, preferably emits light having a light emission peak wavelength that is 680 nm or more and 1,600 nm or less in the light emission spectrum of the oxide phosphor. The excitation light may be light having a light emission peak wavelength that is 365 nm or more and 650 nm or less. The phosphor particles, upon irradiation with light having a light emission peak wavelength that is 365 nm or more and 650 nm or less, preferably emit light having a light emission peak wavelength that is 680 nm or more and 1,600 nm or less, may emit light having a light emission peak wavelength that is 680 nm or more and 1,000 nm or less, may emit light having a light emission peak wavelength that is 690 nm or more and 900 nm or less, or may emit light having a light emission peak wavelength that is 700 nm or more and 800 nm or less. The phosphor particles having a composition represented by the formula (1), upon irradiation with light having a light emission peak wavelength that is 365 nm or more and 650 nm or less, preferably emit light having a light emission peak wavelength that is 680 nm or more and 1,600 nm or less in the light emission spectrum of the oxide phosphor.

The phosphor particles having a composition represented by the formula (1) preferably have a full width at half maximum that is 5 nm or more and 200 nm or less, more preferably 50 nm or more and 180 nm or less, and even more preferably 100 nm or more and 160 nm or less, in the light emission spectrum of the oxide phosphor. In the present specification, the full width at half maximum refers to a wavelength width where the light emission intensity is 50% of the maximum light emission intensity in the light emission spectrum at the light emission peak wavelength. Light is absorbed and scattered in a living body, and to measure a subtle change in the propagation behavior of light in the blood in a living body, it is preferable to irradiate light having a light emission peak with a wide full width at half maximum. In the case of non-destructive measurement of food such as fruits and vegetables, it is also preferable to irradiate light having a light emission spectrum with a wide full width at half maximum to obtain information on the inside of the food. For the color appearance of an object when irradiated with light (hereinafter, also referred to as "color rendering property"), it is desirable to exhibit a light emission spectrum in a wider wavelength range, and the wider the full width at half maximum, the better the color rendering property of light can be emitted. For example, when used in a work environment such as a factory, it may be necessary to emit light that does not disturb the spectral balance of the light in the work environment so that workers can work comfortably.

The phosphor particles having a composition represented by the formula (2), upon irradiation with excitation light having a light emission peak wavelength of 365 nm or more and 650 nm or less, preferably emits light having a light emission peak wavelength that is 680 nm or more and 1,600 nm or less, more preferably 800 nm or more and 1,600 nm or less, in the light emission spectrum of the oxide phosphor. The phosphor particles, upon irradiation with light having a light emission peak wavelength that is 365 nm or more and 650 nm or less, may emit light having a light emission peak wavelength that is 810 nm or more and 1,500 nm or less, may emit light having a light emission peak wavelength that is 820 nm or more and 1,400 nm or less, or may emit light having a light emission peak wavelength that is 820 nm or more and 1,350 nm or less, in the light emission spectrum of the oxide phosphor. The phosphor particles having a composition represented by the formula (2), upon irradiation with light having a light emission peak wavelength that is 365 nm or more and 650 nm or less, preferably emits light having a light emission peak wavelength that is 800 nm or more and 1,600 nm or less in the light emission spectrum of the oxide phosphor.

The phosphor particles having a composition represented by the formula (2) preferably exhibits a full width at half maximum of 150 nm or more and 350 nm or less in the light emission spectrum of the oxide phosphor in order to emit light that allows for easily obtaining information inside living bodies or food and does not disturb the spectral balance of the light. The phosphor particles having a composition represented by the formula (2) may exhibit a full width at half maximum of 160 nm or more and 340 nm or less, or 170 nm or more and 330 nm or less. The phosphor particles having a composition represented by the formula (2), when it has a light emission peak wavelength that is 800 nm or more and 1,600 nm or less in the light emission spectrum of the oxide phosphor, preferably exhibits a full width at half maximum of 150 nm or more and 250 nm or less, more preferably 160 nm or more and 245 nm or less, in the light emission spectrum. In the light emission spectrum of the oxide phosphor, the full width at half maximum may be 160 nm or more, may be 170 nm or more, may be 180 nm or more, or may be 190 nm or more. The phosphor particles having a composition represented by the formula (2), when it has a light emission peak wavelength that is more than 1,000 nm and 1,600 nm or less, for example, 1,001 nm or more and 1,600 nm or less in the light emission spectrum of the oxide phosphor, preferably exhibits a full width at half maximum of 150 nm or more and 350 nm or less, more preferably 180 nm or more and 340 nm or less, even more preferably 200 nm or more and 330 nm or less, and still more preferably 205 nm or more and 330 nm or less, in the light emission spectrum.

The phosphor particles having a composition represented by the formula (3), upon irradiation with excitation light, preferably emits light having a light emission peak wavelength that is 680 nm or more and 1,600 nm or less, more preferably 690 nm or more and 1,500 nm or less, and even more preferably 700 nm or more and 1,300 nm or less, in the light emission spectrum of the oxide phosphor. The excitation light may have a light emission peak wavelength that is 365 nm or more and 650 nm or less. The phosphor particles having a composition represented by the formula (3), when it contains no Ni, i.e., when y3 = 0, preferably emits light having a light emission peak wavelength that is 700 nm or more and 900 nm or less, more preferably 710 nm or more and 850 nm or less, in the light emission spectrum of the oxide phosphor upon irradiation with excitation light.

In order to facilitate obtaining information inside living bodies or food without disturbing the spectral balance of the light, the phosphor particles having a composition included in the composition formula represented by the formula (3) preferably exhibits the full width at half maximum of 150 nm or more and 250 nm or less, more preferably 155 nm or more, and may exhibit the full width at half maximum of 240 nm or less, or 235 nm or less, in the light emission spectrum of the oxide phosphor.

The light emitting device includes the oxide phosphor described above, and a light emitting element being configured to irradiate the oxide phosphor with excitation light and having a light emission peak wavelength that is 365 nm or more and 650 nm or less. The oxide phosphor is preferably contained in a wavelength conversion member, and the wavelength conversion member may contain a light-transmissive material.

A semiconductor element can be used as the light emitting element configured to irradiate the oxide phosphor with excitation light. For example, a nitride semiconductor can be selected as the material for the light emitting element that emits green or blue light. Materials such as In_{X}Al_{Y}Ga_{1-X-Y}N (0 ≤ X ≤ 1, 0 ≤ Y ≤ 1, X+Y ≤ 1) can be used as the material for the semiconductor structure constituting the light emitting element. For example, a gallium-aluminum-arsenic semiconductor or an aluminum-indium-gallium-phosphorus semiconductor can be selected as the material for the light emitting element that emits red light. For example, an LED chip or an LD chip is preferably used for the light emitting element.

The light emitting element has a light emission peak wavelength of 365 nm or more and 650 nm or less, may have a light emission peak wavelength of 365 nm or more and 500 nm or less, may have a light emission peak wavelength of 370 nm or more and 490 nm or less, or may have a light emission peak wavelength of 375 nm or more and 480 nm or less. The light emitting element may have a light emission peak wavelength of more than 500 nm and 650 nm or less, may have a light emission peak wavelength of 510 nm or more and 650 nm or less, or may have a light emission peak wavelength of 520 nm or more and 650 nm or less. Using the light emitting element as the excitation light source of the oxide phosphor allows for constituting a light emitting device that emits mixed color light in which light emitted from the light emitting element and fluorescence emitted from the phosphor containing the oxide phosphor in a desired wavelength range. The full width at half maximum of the light emission peak in the light emission spectrum of the light emitting element can be, for example, 30 nm or less. For example, a light emitting element using a nitride-based semiconductor is preferably used for the light emitting element. Using the light emitting element using a nitride-based semiconductor as the excitation light source allows for obtaining a stable light emitting device having high efficiency, high input-output linearity, and high resistance to mechanical impacts.

The light emitting device includes a first phosphor containing the oxide phosphor described above and may further include a phosphor having a composition different from that. The light emitting device preferably includes, in addition to the first phosphor, at least one phosphor selected from the group consisting of a second phosphor having a light emission peak wavelength of 455 nm or more and less than 495 nm, a third phosphor having a light emission peak wavelength of 495 nm or more and less than 610 nm, a fourth phosphor having a light emission peak wavelength of 610 nm or more and less than 700 nm, and a fifth phosphor having a light emission peak wavelength of 700 nm or more and 1,600 nm or less, in the light emission spectrums of respective phosphors. When the light emitting device includes a light emitting element, a first phosphor containing the oxide phosphor described above, and at least one phosphor selected from the group consisting of a second phosphor, a third phosphor, a fourth phosphor, and a fifth phosphor, the light emitting device can be used as a light source that emits light having a light emission spectrum in a wavelength range from visible light to a part of near-infrared light. The light emitting device can be used as a light source that has a light emission spectrum like that of conventionally used tungsten and xenon lamps and can be reduced in size compared to tungsten and xenon lamps. A small light emitting device can be mounted on small mobile devices such as smartphones and smartwatches to obtain information in a living body, which can be used to manage physical conditions.

The light emitting device can be used, for example, in a reflection spectroscopic measuring device, and a lighting device that allows non-destructively measurement in a living body, fruits, vegetables, and the like and that requires light of a good color rendering property.

The second phosphor, which has a composition different from that of the first phosphor containing the oxide phosphor described above, preferably contains at least one phosphor selected from the group consisting of a phosphate phosphor having a composition represented by the following formula (4a), an aluminate phosphor having a composition represented by the following formula (4b), and an aluminate phosphor having a composition represented by the following formula (4c); and may contain two or more phosphors of these.

(Ca,Sr,Ba,Mg)₁₀(PO₄)₆(F,Cl,Br,I)₂:Eu (4a)

(Ba,Sr,Ca)MgAl₁₀O₁₇:Eu (4b)

Sr₄Al₁₄O₂₅:Eu (4c)

In the present specification, plural elements sectioned by comma (,) in the composition formulae mean that at least one of these plural elements is contained in the composition.

The third phosphor preferably contains at least one phosphor selected from the group consisting of a silicate phosphor having a composition represented by the following formula (5a), an aluminate phosphor or a gallate phosphor having a composition represented by the following formula (5b), a β-SiAlON phosphor having a composition represented by the following formula (5c), a cesium lead halide phosphor having a composition represented by the following formula (5d), and a nitride phosphor having a composition represented by the following formula (5e); and may contain two or more phosphors of these. In the case where the third phosphor contains two or more phosphors, the two or more third phosphors preferably have light emission peak wavelengths in different ranges within a range of 495 nm or more and less than 610 nm.

(Ca,Sr,Ba)₈MgSi₄O₁₆(F,Cl,Br)₂:Eu (5a)

(Lu,Y,Gd,Tb)₃(Al,Ga)₅O₁₂:Ce (5b)

Si_{6-z}Al_{z}O_{z}N_{8-z}:Eu (0 < z ≤ 4.2) (5c)

CsPb(F,Cl,Br)₃ (5d)

(La,Y,Gd)₃Si₆N₁₁:Ce (5e)

The fourth phosphor preferably contains at least one phosphor selected from the group consisting of a nitride phosphor having a composition represented by the following formula (6a), a fluoro-germanate phosphor having a composition represented by the following formula (6b), an oxynitride phosphor having a composition represented by the following formula (6c), a fluoride phosphor having a composition represented by the following formula (6d), a fluoride phosphor having a composition represented by the following formula (6e), a nitride phosphor having a composition represented by the following formula (6f), and a nitride phosphor having a composition represented by the following formula (6g); and may contain two or more phosphors of these. In the case where the fourth phosphor contains two or more phosphors, the two or more fourth phosphors preferably have light emission peak wavelengths in different ranges within a range of 610 nm or more and less than 700 nm.

(Sr,Ca)AlSiN₃:Eu (6a)

3.5MgO·0.5MgF₂·GeO₂:Mn (6b)

(Ca,Sr,Mg)ₖSi₁₂₋₍ₘ₊ₙ₎Alₘ₊ₙOₙN₁₆₋ₙ:Eu (6c)

wherein k, m, and n satisfy 0 < k ≤ 2.0, 2.0 ≤ m ≤ 6.0, and 0 ≤ n ≤ 2.0.

A¹_{c1}[M⁶_{1-b1}Mn⁴⁺_{b1}F_{d1}] (6d)

wherein A¹ includes at least one selected from the group consisting of K⁺, Li⁺, Na⁺, Rb⁺, Cs⁺, and NH₄⁺, among which K⁺ is preferred; M⁶ includes at least one element selected from the group consisting of Group 4 elements and Group 14 elements, among which Si and Ge are preferred; b1 satisfies 0 < b1 < 0.2; c1 represents the absolute value of the charge of [M⁶_{1-b1}Mn⁴⁺_{b1}F_{d1}] ions; and d1 satisfies 5 < d1 < 7.

A²_{c2}[M⁷_{1-d2}Mn⁴⁺_{b2}F_{d2}] (6e)

wherein A² includes at least one selected from the group consisting of K⁺, Li⁺, Na⁺, Rb⁺, Cs⁺, and NH₄⁺, among which K⁺ is preferred; M⁷ includes a Group 13 element, and may further include at least one element selected from the group consisting of Group 4 elements and Group 14 elements, among which Al is preferred in the Group 13 elements and Si is preferred in the Group 14 elements; b2 satisfies 0 < b2 < 0.2; c2 represents the absolute value of the charge of [M⁷_{1-b2}Mn⁴⁺_{b2}F_{d2}] ions; and d2 satisfies 5 < d2 < 7.

(Ba,Sr,Ca)₂Si₅N₈:Eu (6f)

(Sr,Ca)Li(Al,Ga)₃N₄:Eu (6g)

The fifth phosphor preferably contains at least one phosphor selected from the group consisting of a gallate phosphor having a composition represented by the following formula (7a), an aluminate phosphor having a composition represented by the following formula (7b), a phosphor having a composition represented by the following formula (7c) and different from those of the above oxide phosphors, a phosphor having a composition represented by the following formula (7d) and different from those of the above oxide phosphors, a phosphor having a composition represented by the following formula (7e) and different from those of the above oxide phosphors, a phosphor having a composition represented by the following formula (7f) and different from those of the above oxide phosphors, a phosphor having a composition represented by the following formula (7g) and different from those of the above oxide phosphors, a phosphor having a composition represented by the following formula (7h) and different from those of the above oxide phosphors, a phosphor having a composition represented by the following formula (7i) and different from those of the above oxide phosphors, a phosphor having a composition represented by the following formula (7j) and different from those of the above oxide phosphors, and a phosphor having a composition represented by the following formula (7k) and different from those of the above oxide phosphors; and may contain two or more phosphors of these.

ZnGa₂O₄:Cr (7a)

(Lu,Y,Gd,Tb)₃(Al,Ga)₅O₁₂:Ce,Cr (7b)

M⁸_{g}M⁹ₕM¹⁰ᵢM¹¹₅Oⱼ:Crₑ,M¹²_{f} (7c)

wherein M⁸ represents at least one element selected from the group consisting of Li, Na, K, Rb, and Cs; M⁹ represents at least one element selected from the group consisting of Mg, Ca, Sr, Ba, and Zn; M¹⁰ represents at least one element selected from the group consisting of Ba, Al, Ga, In, and rare earth elements; M¹¹ represents at least one element selected from the group consisting of Si, Ti, Ge, Zr, Sn, Hf, and Pb; M¹² represents at least one element selected from the group consisting of Eu, Ce, Tb, Pr, Nd, Sm, Yb, Ho, Er, Tm, Ni, and Mn; and e, f, g, h, i, and j satisfy 0 < e ≤ 0.2, 0 ≤ f ≤ 0.1, f < e, 0.7 ≤ g ≤ 1.3, 1.5 ≤ h ≤ 2.5, 0.7 ≤ i ≤ 1.3, and 12.9 ≤ j ≤ 15.1.

(

Ga₁₋ᵤ₄M¹³ᵤ₄)₂(Ge₁₋ᵥ₄M¹⁴ᵥ₄)_{w4}Oₓ₄:Cr_{y4},M¹⁵_{z4} (7d)

wherein M¹³ represents at least one element selected from the group consisting of Al, Sc, and In; M¹⁴ represents at least one element selected from the group consisting of Si, Ti, Zr, Sn, and Hf; M¹⁵ represents at least one element selected from the group consisting of Ni, Eu, Fe, Mn, Nd, Tm, Ho, Er, and Yb; and u4, v4, w4, x4, y4, and z4 satisfy 0 ≤ u4 ≤ 1.0, 0 ≤ v4 ≤ 0.5, 1.0 ≤ w4 ≤ 3.0, 5 ≤ x4 ≤ 9, 0.005 ≤ y4 ≤ 1.0, and 0 ≤ z4 ≤ 0.5.

(

Mg₁₋ₛ₅M¹⁶ₛ₅)₂(Al₁₋ₜ₅M¹⁷ₜ₅)ᵤ₅(Ge₁₋ᵥ₅M¹⁸ᵥ₅)_{w5}Oₓ₅:Cr_{y5}M¹⁹_{z5} (7e)

wherein M¹⁶ represents at least one element selected from the group consisting of Ca, Sr, Ba, and Zn; M¹⁷ represents at least one element selected from the group consisting of Ga, Sc, and In; M¹⁸ represents at least one element selected from the group consisting of Si, Ti, Zr, Sn, and Hf; M¹⁹ represents at least one element selected from the group consisting of Ni, Ce, Eu, Fe, Mn, Nd, Tm, Ho, Er, and Yb; and s5, t5, u5, v5, w5, x5, y5, and z5 satisfy 0 ≤ s5 ≤ 1.0, 0 ≤ t5 ≤ 1.0, 1.5 ≤ u5 ≤ 2.5, 0 ≤ v5 ≤ 0.5, 3.0 ≤ w5 ≤ 6.0, 11.0 ≤ x5 ≤ 17.0, 0.005 ≤ y5 ≤ 1.0, and 0 ≤ z5 ≤ 0.5.

M

²⁰ₓ₆(Al_{1-y6}M²¹_{y6})_{z6}O_{x6+3/2z6}:Crᵥ₆,M²²_{w6} (7f)

wherein M²⁰ represents at least one element selected from the group consisting of alkaline earth metal elements; M²¹ represents at least one element selected from the group consisting of Group 13 elements excluding Al; M²² represents at least one element selected from the group consisting of Mn, Eu, Ce, Tb, Pr, Nd, Sm, Yb, Ho, Er, and Tm; and v6, w6, x6, y6, and z6 satisfy 0.004 ≤ v6 ≤ 0.8, 0 ≤ w6 ≤ 0.4, 0.004 ≤ v6+w6 ≤ 0.8, 1.0 ≤ x6 ≤ 4.0, 0 ≤ y6 ≤ 0.7, and 4.0 ≤ z6 ≤ 1.50.

m²

³ₜ₇M²⁴ᵤ₇(Ge₁₋ᵥ₇M²⁵ᵥ₇)₆O_{w7}:Crₓ₇,M²⁶_{y7} (7g)

wherein M²³ represents at least one element selected from the group consisting of Li, Na, K, Rb, and Cs; M²⁴ represents at least one element selected from the group consisting of Ca, Sr, Mg, Ba, and Zn; M²⁵ represents at least one element selected from the group consisting of Si, Ti, Zr, Sn, Hf, and Pb; M²⁶ represents at least one element selected from the group consisting of Eu, Ce, Tb, Pr, Nd, Sm, Yb, Ho, Er, Tm, Ni, and Mn; and t7, u7, v7, w7, x7, and y7 satisfy 1.5 ≤ t7 ≤ 2.5, 0.7 ≤ u7 ≤ 1.3, 0 ≤ v7 ≤ 0.4, 12.9 ≤ w7 ≤ 15.1, 0 < x7 ≤ 0.2, 0 ≤ y7 ≤ 0.10, and y7 < x7.

(

Li₁₋ᵤ₈M²⁷ᵤ₈)₄(Ge₁₋ᵥ₈M²ᵥ₈)_{w8}Oₓ₈:Cr_{y8}M²⁹_{z8} (7h)

wherein M²⁷ represents at least one element selected from the group consisting of Na, K, Rb, and Cs; M²⁸ represents at least one element selected from the group consisting of Si, Ti, Zr, Sn, and Hf; M²⁹ represents at least one element selected from the group consisting of Ni, Eu, Fe, Mn, Nd, Tm, Ho, Er, and Yb; and u8, v8, w8, x8, y8, and z8 satisfy 0 ≤ u8 ≤ 0.3, 0 ≤ v8 ≤ 0.5, 3.5 ≤ w8 ≤ 15, 9 ≤ x8 ≤ 32, 0.005 ≤ y8 ≤ 1.0, and 0 ≤ z8 ≤ 0.5.

(

Li₁₋ᵤ₉M³⁰ᵤ₉)₂M³¹ᵥ₉M³²_{w9}Oₓ₉:Cr_{y9},M³³_{z9} (7i)

wherein M³⁰ represents at least one element selected from the group consisting of Na, K, Rb, and Cs; M³¹ represents at least one element selected from the group consisting of Mg, Ca, Sr, Ba, and Zn; M³² represents at least one element selected from the group consisting of Si, Ge, Ti, Zr, Sn, and Hf; M³³ represents at least one element selected from the group consisting of Ni, Eu, Fe, Mn, Nd, Tm, Ho, Er, and Yb; and u9, v9, w9, x9, y9, and z9 satisfy 0 ≤ u9 ≤ 1.0, 0.8 ≤ v9 ≤ 3.0, 1.8 ≤ w9 ≤ 6, 5.4 ≤ x9 ≤ 16, 0.005 ≤ y9 ≤ 1.0, and 0 ≤ z9 ≤ 0.5.

(M

g₁₋ₚ₁₀M³⁴ₚ₁₀)_{q10}(Li₁₋ᵣ₁₀M³⁵ᵣ₁₀)ₛ₁₀(In₁₋ₜ₁₀M³⁶ₜ₁₀)ᵤ₁₀(Ge₁₋ᵥ₁₀M³⁷ᵥ₁₀)_{w10}Oₓ₁₀:Cr_{y10},M³⁸_{z10} (7j)

wherein M³⁴ represents at least one element selected from the group consisting of Ca, Sr, Ba, and Zn; M³⁵ represents at least one element selected from the group consisting of Na, K, Rb, and Cs; M³⁶ represents at least one element selected from the group consisting of Al, Ga, and Sc; M³⁷ represents at least one element selected from the group consisting of Si, Ti, Zr, Sn, and Hf; M³⁸ represents at least one element selected from the group consisting of Ni, Ce, Eu, Fe, Mn, Nd, Tm, Ho, Er, and Yb; and p10, q10, r10, s10, t10, u10, v10, w10, x10, y10, and z10 satisfy 0 ≤ p10 ≤ 1.0, 0.1 ≤ q10 ≤ 0.9, 0 ≤ r10 ≤ 1.0, 0.05 ≤ s10 ≤ 0.45, 0 ≤ t10 ≤ 0.5, 0.05 ≤ u10 ≤ 0.45, 0 ≤ v10 ≤ 1.0, 0.8 ≤ w10 ≤ 1.3, 2.6 ≤ x10 ≤ 3.6, 0.02 ≤ y10 ≤ 0.5, 0 ≤ z10 ≤ 0.3, and 0.9 ≤ q10+s10+u10 ≤ 1.2.

(

Li_{1-q11}M³⁹_{q11})ᵣ₁₁(Mg₁₋ₛ₁₁M⁴⁰ₛ₁₁)ₜ₁₁(Ta₁₋ᵤ₁₁₋ᵥ₁₁Nbᵤ₁₁M⁴¹ᵥ₁₁)_{w11}Oₓ₁₁:Cr_{y11},M⁴²z₁₁ (7k)

wherein M³⁹ represents at least one element selected from the group consisting of Na, K, Rb, and Cs; M⁴⁰ represents at least one element selected from the group consisting of Zn, Ca, Sr, and Ba; M⁴¹ represents at least one element selected from the group consisting of P, V, Sb, and Bi; M⁴² represents at least one element selected from the group consisting of Ni, Ce, Eu, Fe, Mn, Nd, Tm, Ho, Er, and Yb; and q11, r11, s11, t11, u11, v11, w11, x11, y11, and z11 satisfy 0 ≤ q11 ≤ 0.5, 0.5 ≤ r11 ≤ 3.5, 0 ≤ s11 ≤ 0.5, 1.8 ≤ t11 ≤ 3.2, 0 ≤ u11 ≤ 1.0, 0 ≤ v11 ≤ 0.3, 0 ≤ u11+v11 ≤ 1.0, 0.8 ≤ w11 ≤ 1.2, 5.1 ≤ x11 ≤ 6.9, 0.002 ≤ y11 ≤ 0.5, and 0 ≤ z11 ≤ 0.3.

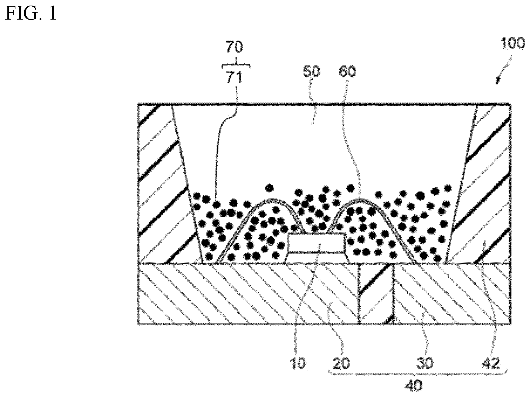

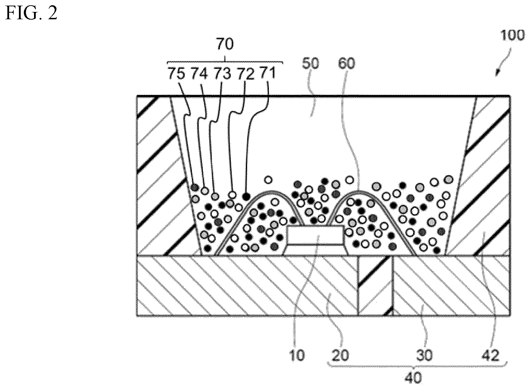

An example of the light emitting device will be described below with reference to the drawings. FIG. 1 is a schematic cross-sectional view showing an exemplary light emitting device according to a first embodiment of the present disclosure. FIG. 2 is a schematic cross-sectional view showing another exemplary light emitting device according to the first embodiment of the present disclosure.

As shown in FIG. 1, a light emitting device 100 includes a molded body 40 defining a recess, a light emitting element 10 serving as an excitation light source, and a wavelength conversion member 50 that covers the light emitting element 10. The molded body 40 is formed by integrally molding together a first lead 20, a second lead 30, and a resin portion 42 containing a thermoplastic resin or a thermosetting resin. In the molded body 40, at least the first lead 20 and the second lead 30 constitute a surface defining the bottom of the recess, and at least the resin portion 42 constitutes the lateral surface(s) defining lateral sides of the recess. The light emitting element 10 is mounted on the surface defining the bottom of the recess of the molded body 40. The light emitting element 10 has positive and negative electrodes, and the positive and negative electrodes are respectively electrically connected to the first lead 20 and the second lead 30 via wires 60. The light emitting element 10 is covered by the wavelength conversion member 50. The wavelength conversion member 50 preferably includes a phosphor 70 that converts the wavelength of light emitted from the light emitting element 10, and a light-transmissive material. The phosphor 70 essentially contains a first phosphor 71 containing an oxide phosphor. The oxide phosphor contained in the first phosphor 71 contains at least one type of phosphor particles selected from the group consisting of phosphor particles having a composition represented by the formula (1), phosphor particles having a composition represented by the formula (2), and phosphor particles having a composition represented by the formula (3), and the oxide phosphor contained in the first phosphor may contain two or more types of oxide phosphors containing phosphor particles having different compositions. The phosphor 70 may contain a phosphor having a light emission peak wavelength in a wavelength range different from that of the first phosphor 71 and having a composition different from that of the first phosphor 71. As shown in FIG. 2, the phosphor 70 preferably contains at least one phosphor selected from the group consisting of the second phosphor 72, the third phosphor 73, the fourth phosphor 74, and the fifth phosphor 75 described above, and may contain two or more types of these. The phosphor 70 essentially contains the first phosphor 71, and may contain the second phosphor 72, the third phosphor 73, the fourth phosphor 74, and the fifth phosphor 75. The wavelength conversion member 50 also functions as a member for protecting, for example, the light emitting element 10, the wires 60, and the phosphor 70 from the external environment. The light emitting device 100 emits light upon receiving external electric power through the first lead 20 and the second lead 30.

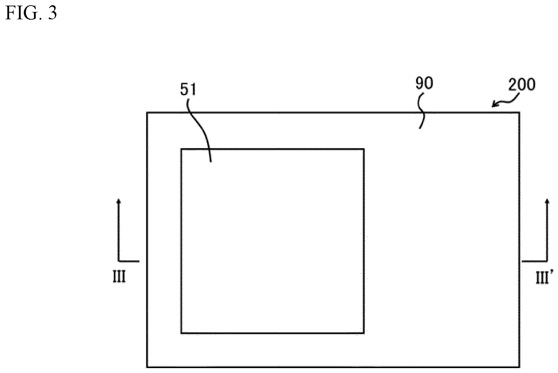

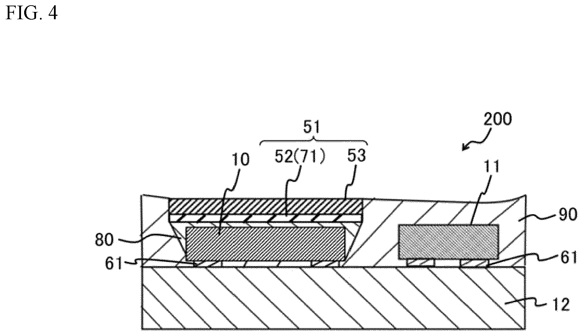

FIGS. 3 and 4 show an exemplary light emitting device according to a second embodiment of the present disclosure. FIG. 3 is a schematic plan view of a light emitting device 200. FIG. 4 is a schematic cross-sectional view of the III-III' line of the light emitting device 200 shown in FIG. 3. The light emitting device 200 includes a light emitting element 10 having a light emission peak wavelength of 365 nm or more and 650 nm or less, and a wavelength conversion member 51. The wavelength conversion member 51 includes a wavelength conversion body 52 containing a first phosphor 71 that is adapted to be excited by light emitted from the light emitting element 10 and to emit light, and a light-transmissive body 53 disposed on the light emitting surface side of the wavelength conversion body 52. The light emitting element 10 is flip chip mounted on a substrate 12 via bumps that are conductive members 61. The wavelength conversion body 52 of the wavelength conversion member 51 is disposed on the light emitting surface of the light emitting element 10 via an adhesive layer 80. The lateral surface(s) of the light emitting element 10 and the lateral surface(s) of the wavelength conversion member 51 are covered with a covering member 90 that reflects light. The wavelength conversion body 52 essentially contains a first phosphor 71 adapted to be excited by light emitted from the light emitting element 10. The first phosphor contains an oxide phosphor containing phosphor particles, containing a host crystal containing Ga and oxygen and an activating element, and first compound particles and/or second compound particles disposed on the surfaces of the phosphor particles. The oxide phosphor contained in the first phosphor 71 contains at least one type of phosphor particles selected from the group consisting of phosphor particles having a composition represented by the formula (1), phosphor particles having a composition represented by the formula (2), and phosphor particles having a composition represented by the formula (3), and the oxide phosphor contained in the first phosphor may contain two or more types of oxide phosphors each containing phosphor particles having a different composition. The wavelength conversion body 52 may contain at least one selected from the group consisting of the second phosphor, the third phosphor, the fourth phosphor, and the fifth phosphor. The light emitting element 10 receives electric power from the outside of the light emitting device 200 via the conductive member and the conductive members 61 formed on the substrate 12, thereby enabling the light emitting device 200 to emit light. The light emitting device 200 may include a semiconductor element 11 such as a protective element for preventing the light emitting element 10 from being broken due to excessive voltage application. The semiconductor element 11 may be mounted on the substrate 12 via the conductive members 61. The covering member 90 is disposed to cover, for example, the semiconductor element 11. Members used in the light emitting device is described below. For the details, for example, the disclosure of Japanese Unexamined Patent Publication No. 2014-112635 may be referenced.

Examples of the light-transmissive material constituting the wavelength conversion body together with the phosphor include at least one selected from the group consisting of resin, glass, and inorganic substances. As the resin, at least one resin selected from the group consisting of a silicone resin, an epoxy resin, a phenol resin, a polycarbonate resin, an acrylic resin, and modified resins thereof can be used. Among them, a silicone resin and a modified silicone resin are preferred because of their good heat and light resistance. The wavelength conversion member may optionally contain a filler, a colorant, and a light diffusing material in addition to the phosphor and the light-transmissive material. Examples of the filler include silicon oxide, barium titanate, titanium oxide, and aluminum oxide.

As the light-transmissive body, a plate-shaped body formed of a light-transmissive material such as glass or resin can be used. Examples of the glass include borosilicate glass and quartz glass. Examples of the resin include a silicone resin and an epoxy resin. When the wavelength conversion member includes a substrate, the substrate is preferably formed of an insulating material that is difficult to transmit light emitted from the light emitting element and external light. Examples of the material of the substrate include ceramics such as aluminum oxide and aluminum nitride, and resins such as a phenol resin, an epoxy resin, a polyimide resin, a bismaleimide triazine resin (BT resin), and a polyphthalamide (PPA) resin. When an adhesive layer is disposed between the light emitting element and the wavelength conversion member, the adhesive constituting the adhesive layer is preferably formed of a material capable of optically connecting the light emitting element and the wavelength conversion member. The material constituting the adhesive layer is preferably at least one resin selected from the group consisting of an epoxy resin, a silicone resin, a phenol resin, and a polyimide resin. The light-transmissive body is not needed to be disposed on the wavelength conversion member.

Examples of the semiconductor element optionally disposed in the light emitting device include a transistor for controlling the light emitting element and a protective element for inhibiting the destruction and the performance deterioration of the light emitting element due to excessive voltage application. Examples of the protective element include a Zener diode. When the light emitting device includes a covering member, it is preferable to use an insulating material as the material of the covering member. More specific examples thereof include a phenol resin, an epoxy resin, a bismaleimide triazine resin (BT resin), a polyphthalamide (PPA) resin, and a silicone resin. A colorant, a phosphor, and a filler may be optionally added to the covering member. In the light emitting device, bumps may be used as conductive members. Examples of the material of the bumps include Au and an alloy thereof, and examples of the other conductive member include eutectic solder (Au-Sn), Pb-Sn, and lead-free solder.

An example of the method for producing an exemplary light emitting device according to the first embodiment is described below. For the details, for example, the disclosure of Japanese Unexamined Patent Publication No. 2010-062272 may be referred to. The method for producing a light emitting device preferably includes a step of providing a molded body, a step of disposing a light emitting element, a step of disposing a composite for forming the wavelength conversion, and a step of forming a resin package. When using a collective molded body having a plurality of recesses, the method of producing may include, after the step of forming a resin package, a singulating step of separating into individual resin packages for respective unit regions.

In the step of providing a molded body, a plurality of leads and a thermosetting resin or a thermoplastic resin are integrally molded together to provide a molded body having a recess with surfaces defining lateral side(s) and a bottom of the recess. The molded body may be formed of a collective base member including a plurality of recesses.

In the step of disposing a light emitting element, a light emitting element is disposed on the surface defining the bottom of the recess of the molded body, and the positive and negative electrodes of the light emitting element are connected to the first lead and the second lead, respectively, by wires.

In the step of disposing a composite for forming the wavelength conversion member, a composite for forming the wavelength conversion member is disposed in the recess of the molded body.

In the step of forming a resin package, the composite for forming the wavelength conversion member disposed in the recess of the molded body is cured to form a resin package, thereby producing a light emitting device. When using a molded body formed of a collective base member having a plurality of recesses, in the singulating step after the step of forming a resin package, the molded body is separated for each resin package in each unit region from the collective base member having a plurality of recesses, so that individual light emitting devices is produced. As described above, the light emitting devices shown in FIGS. 1 and 2 can be produced.

An example of the method for producing an exemplary light emitting device according to the second embodiment is described below. For the details, for example, the disclosure of Japanese Unexamined Patent Publication No. 2014-112635 or Japanese Unexamined Patent Publication No. 2017-117912 may be referenced. The method for producing a light emitting device preferably includes a step of disposing a light emitting element, a step of disposing a semiconductor element that is optionally performed, a step of forming a wavelength conversion member including a wavelength conversion body, a step of adhering a light emitting element and a wavelength conversion member, and a step of forming a covering member.

For example, in the step of disposing a light emitting element, a light emitting element is disposed on a substrate. The light emitting element, and a semiconductor element are flip chip mounted, for example, on the substrate. Subsequently, in the step of forming a wavelength conversion member including a wavelength conversion body, a wavelength conversion body may be obtained by forming a plate-shaped, sheet-shaped, or layered wavelength conversion body on a surface of a light-transmissive body by a printing method, an adhesive method, a compression molding method, or an electrodeposition method. For example, in the printing method, a wavelength conversion body composition containing a phosphor and a resin serving as a binder or a solvent can be printed on the surface of the light-transmissive body to form a wavelength conversion member including a wavelength conversion body. Subsequently, in the step of adhering a light emitting element and a wavelength conversion member, the wavelength conversion member is allowed to face to the light emitting surface of the light emitting element, and the wavelength conversion member is adhered onto the light emitting element by an adhesive layer. Subsequently, in the step of forming a covering member, the lateral surfaces of the light emitting element, and the wavelength conversion member are covered with the composition for a covering member. The covering member is configured to reflect light emitted from the light emitting element, and when the light emitting device includes a semiconductor element, it is preferable to form the covering member such that the semiconductor element is embedded by the covering member. In this manner, the light emitting device shown in FIGS. 3 and 4 can be produced.

The method for producing an oxide phosphor includes: providing a raw material mixture containing a compound containing Ga and a compound containing Cr serving as an activating element; providing a first flux containing an oxide containing at least one first element selected from the group consisting of Group 4 elements, Group 5 elements, Group 14 elements, and Group 15 elements; mixing the raw material mixture and the first flux to obtain a mixture; and heat-treating the mixture to obtain an oxide phosphor containing phosphor particles and first compound particles containing the first element disposed on the surface of the phosphor particles. In providing a raw material mixture in the method for producing an oxide phosphor, the raw material mixture may contain a compound containing an element other than Cr that serves as an activating element.

In the method for producing an oxide phosphor, a mixture obtained by mixing a raw material mixture and a first flux containing an oxide containing at least one first element selected from the group consisting of Group 4 elements, Group 5 elements, Group 14 elements, and Group 15 elements is heat-treated to facilitate the reaction of the compounds contained in the raw material mixture and to grow the crystals, thereby obtaining an oxide phosphor having a large particle diameter. The oxide containing a first element contained in the first flux is adhered to the surfaces of the oxide phosphor particles in the form of particles or a film. The oxide phosphor having a large particle diameter due to crystal growth can have an increased light emission intensity.

The method for producing an oxide phosphor includes: providing a raw material mixture containing a compound containing Ga and a compound containing Cr serving as an activating element; providing a first flux containing an oxide containing at least one first element selected from the group consisting of Group 4 elements, Group 5 elements, Group 14 elements, and Group 15 elements; providing a second flux containing a compound containing at least one second element selected from the group consisting of alkali metal elements and alkaline earth metal elements; mixing the raw material mixture, the first flux, and the second flux to obtain a mixture; and obtaining an oxide phosphor containing phosphor particles, heat-treating the mixture to obtain first compound particles containing the first element disposed on the surface of the phosphor particles, and second compound particles containing the second element disposed on the surface of the phosphor particles. In providing a raw material mixture in the method for producing an oxide phosphor, the raw material mixture may contain a compound containing an element other than Cr that serves as an activating element. The first compound particles contain oxide particles.

In the method for producing an oxide phosphor, a mixture obtained by mixing a raw material mixture, a first flux containing an oxide containing at least one first element selected from the group consisting of Group 4 elements, Group 5 elements, Group 14 elements, and Group 15 elements, and a second flux containing a compound containing at least one second element selected from the group consisting of alkali metal elements and alkaline earth metal elements is heat-treated to facilitate the reaction of the compounds contained in the raw material mixture and thus to grow the crystals, thereby obtaining an oxide phosphor having a large particle diameter. The oxide containing a first element contained in the first flux and the compound containing a second element contained in the second flux are adhered to the surfaces of the oxide phosphor particles in the form of second compound particles containing the second element or a film thereof. By increasing the particle diameter of the oxide phosphor, the light emission intensity of that can be increased. The compound containing a first element, contained in the first flux, and the first compound particles, containing a first element and disposed on the surface of the phosphor particles, or the film-shaped first compound, containing a first element, may be the same compounds or different compounds. The compound containing a second element contained in the second flux and the second compound particles containing a second element disposed on the surface of the phosphor particles may be the same compounds or different compounds.

The raw material mixture may contain, in addition to the compound containing Ga constituting the host crystal of the phosphor particles and the compound containing Cr serving as an activating element, a compound containing an element other than both Ga and oxygen and constituting the host crystal of the phosphor particles, and/or a compound containing an element other than Cr and serving as an activating element, as necessary. The method for producing an oxide phosphor may include providing a raw material mixture containing a compound containing Ga, a compound containing Cr serving as an activating element, optionally a compound containing an element other than both Ga and oxygen and constituting the host crystal of the phosphor particles, and optionally a compound containing an element other than Cr and serving as an activating element.

In the case of producing phosphor particles having a composition represented by the formula (1), in one example, the element other than both Ga and oxygen and constituting the host crystal of the phosphor particles having a composition represented by the formula (1) is an element M¹ in the composition represented by the formula (1). In the production of the phosphor particles having a composition represented by the formula (1), it is preferable to provide a raw material mixture containing a compound containing Ga, a compound containing Cr serving as an activating element, and optionally a compound containing an element M¹ that is other than Ga and oxygen and constitutes the host crystal of the phosphor particles. In the production of the phosphor particles having a composition represented by the formula (1), the element M¹, which is other than both Ga and oxygen and is optionally contained, is at least one element selected from the group consisting of Al, In, and rare earth elements. In the production of the phosphor particles having a composition represented by the formula (1), in one example, the compound containing an element that is other than both Ga and oxygen and is optionally contained in the raw material mixture is a compound containing an element M¹ that is at least one element selected from the group consisting of Al, In, and rare earth elements, other than a compound containing Ga.

In the case of producing phosphor particles having a composition represented by the formula (2), in one example, the elements other than Ga and oxygen and constituting the host crystal of the phosphor particles having a composition represented by the formula (2) are Mg and elements M² and M³ in the composition represented by the formula (2). In the phosphor particles having a composition represented by the formula (2), in one example, the element other than Cr serving as an activating element is an element M⁴. In the production of the phosphor particles having a composition represented by the formula (2), it is preferable to provide a raw material mixture containing: a compound containing Ga; a compound containing Cr serving as an activating element; at least one compound selected from the group consisting of an essential compound containing Mg, an optional compound containing an element M², and an optional compound containing an element M³, which are elements other than Ga and oxygen and constitute the host crystal of the phosphor particles; and optionally a compound containing an element M⁴. In the production of the phosphor particles having a composition represented by the formula (2), the element M², which is other than both Ga and oxygen and is optionally contained, is at least one element selected from the group consisting of Ca, Sr, Ba, Ni, and Zn. In the production of the phosphor particles having a composition represented by the formula (2), the element M³, which is other than both Ga and oxygen and is optionally contained, is at least one element selected from the group consisting of B, Al, In, and Sc. In the production of the phosphor particles having a composition represented by the formula (2), the element M⁴, which is other than Cr serving as an activating element and is optionally contained, is at least one element selected from the group consisting of Eu, Ce, Tb, Pr, Nd, Sm, Yb, Ho, Er, Tm, and Mn. In the production of the phosphor particles having a composition represented by the formula (2), examples of the compound containing an element that is other than both Ga and oxygen and is optionally contained in the raw material mixture include a compound containing Mg, a compound containing an element M² that is at least one element selected from the group consisting of Ca, Sr, Ba, Ni, and Zn, and a compound containing an element M³ that is at least one element selected from the group consisting of B, Al, In, and Sc. In the production of the phosphor particles having a composition represented by the formula (2), examples of the compound containing an element that is optionally contained in the raw material mixture and is other than Cr serving as an activating element include a compound containing an element M⁴ that is at least one element selected from the group consisting of Eu, Ce, Tb, Pr, Nd, Sm, Yb, Ho, Er, Tm, and Mn.

In the case of producing phosphor particles having a composition represented by the formula (3), examples of the element other than Ga and oxygen constituting the host crystal of the phosphor particles having a composition represented by the formula (3) includes Li and elements M⁵, M⁶, and M⁷ in the composition represented by the formula (3). In the production of the phosphor particles having a composition represented by the formula (3), it is preferable to provide a raw material mixture containing: a compound containing Ga; a compound containing Cr serving as an activating element; optionally at least one compound selected from the group consisting of a compound containing Li, a compound containing an element M⁵, and a compound containing an element M⁶, which are elements other than Ga and oxygen and constitute the host crystal of the phosphor particles; and optionally a compound containing an element M⁷. In the production of the phosphor particles having a composition represented by the formula (3), the element M⁵, which is other than both Ga and oxygen and is optionally contained, is at least one element selected from the group consisting of Na, K, Rb, and Cs. In the production of the phosphor particles having a composition represented by the formula (3), the element M⁶ , which is other than both Ga and oxygen and is optionally contained, is at least one element selected from the group consisting of B, Al, In, and rare earth elements. The rare earth elements include Sc, Y, La, Ce, Pr, Nd, Pm, Sm, Eu, Gd, Tb, Dy, Ho, Er, Tm, Yb, and Lu. In the production of the phosphor particles having a composition represented by the formula (3), the element M⁷, which is optionally contained, is at least one element selected from the group consisting of Si, Ge, Sn, Ti, Zr, Hf, Bi, V, Nb, and Ta. In the production of the phosphor particles having a composition represented by the formula (3), examples of the compound containing an element that is optionally contained in the raw material mixture and is other than both Ga and oxygen include a compound containing Li, a compound containing an element M⁵ that is at least one element selected from the group consisting of Na, K, Rb, and Cs, a compound containing an element M⁶ that is at least one element selected from the group consisting of B, Al, In, and rare earth elements, and a compound containing an element M⁷ that is at least one element selected from the group consisting of Si, Ge, Sn, Ti, Zr, Hf, Bi, V, Nb, and Ta.

Examples of the compound containing Ga, the compound containing Cr, the compound containing an element that is other than Ga and oxygen constituting the host crystal and is optionally used, and the compound containing an element that is other than Cr serving as an activating element and is optionally used include either oxides or compounds that are stable as compounds and easily formed into oxides. Specific examples of the compounds contained in the raw material mixture include oxides, carbonates, chlorides, and hydrates thereof. Examples of the compound containing Ga include at least one selected from the group consisting of Ga₂O₃, GaCl₂, and GaCl₃. Examples of the compound containing Cr include at least one selected from the group consisting of Cr₂O₃, Cr₂(CO₃)₃, CrCl₂, and CrCl₃.

The compound containing Ga, the compound containing Cr, the compound containing an element that is other than Ga and oxygen constituting the host crystal and is optionally used, and the compound containing an element that is other than Cr serving as an activating element and is optionally used, can be weighed so as to satisfy the composition represented by the formula (1), the composition represented by the formula (2), or the composition represented by the formula (3), and then mixed to obtain a raw material mixture. The compounds may be mixed using a mixing machine. As the mixing machine, for example, a ball mill, a vibration mill, a roll mill, and a jet mill, which are commonly used in industry, can be used.

In providing a first flux, the first flux contains an oxide containing at least one first element selected from the group consisting of Group 4 elements, Group 5 elements, Group 14 elements, and Group 15 elements. In providing a first flux, the first element is preferably at least one selected from the group consisting of Ti, Zr, Hf, V, Nb, Ta, Si, Ge, Sn, P, and Bi. Examples of the oxide containing the first element include TiO₂, ZrO₂, HfO₂, V₂O₅, Nb₂O₅, Ta₂O₅, SiO₂, GeO₂, SnO₂, (NH₄)₃PO₄, (NH₄)₂HPO₄, NH₄H₂PO₄, Sb₂O₃, and Bi₂O₃. The oxide containing the first element is preferably at least one selected from the group consisting of TiO₂, ZrO₂, HfO₂, Nb₂O₅, Ta₂O₅, SiO₂, GeO₂, (NH₄)₃PO₄, (NH₄)₂HPO₄, and NH₄H₂PO₄.

The first flux facilitates the reaction of the compounds contained in the raw material mixture and allows the solid-phase reaction to proceed more uniformly, which allows for obtaining phosphor particles having a large particle diameter and a high light emission intensity in the method for producing an oxide phosphor. The oxide contained in the first flux is adhered to the surface of the resulting phosphor particles in the form of particles or a film. It is presumed that when the temperature at which the liquid phase of the product formed by reacting the compound used as the flux with a part of the raw material mixture is formed is similar to or lower than the temperature of the heat treatment for obtaining phosphor particles, the flux facilitates the reaction of the compounds contained in the raw material mixture. There may be the case where the melting temperature of the oxide containing the first element used as the first flux is higher than the heat treatment temperature. It is preferred that the flux includes a first flux and a second flux, and that the temperature at which the liquid phase of the product formed by reacting the compounds used as these fluxes with a part of the raw material mixture is formed is similar to or lower than the temperature of the heat treatment for obtaining phosphor particles. In this case, it is presumed that the fluxes facilitate the reaction of the compounds contained in the raw material mixture. There may be the case where the elements contained in the first flux are the same as at least some of the elements constituting the oxide phosphor.

The method for producing an oxide phosphor includes obtaining a mixture by mixing the raw material mixture and the first flux. In obtaining a mixture, the first flux is preferably added in an amount of 0.05% by mass or more relative to 100% by mass of the raw material mixture. In obtaining a mixture, when the first flux is added in an amount of 0.05% by mass or more relative to 100% by mass of the raw material mixture, the reaction of the compounds contained in the raw material mixture is facilitated, and thus phosphor particles having a large particle diameter can be obtained. When the first flux is formed from an oxide containing a first element, the oxide containing a first element that is the first flux is preferably added in an amount of 0.05% by mass or more relative to 100% by mass of the raw material mixture. The amount of the first flux added may be 0.1% by mass or more, or may be 0.5% by mass or more, relative to 100% by mass of the raw material mixture. The amount of the first flux added may be 100% by mass relative to 100% by mass of the raw material mixture. The first flux may be added in any amount necessary to facilitate the reaction of the raw material mixture and may be added in an amount of 90% by mass or less, 80% by mass or less, or 70% by mass or less, relative to 100% by mass of the raw material mixture.

In providing a second flux, the second flux contains a compound containing at least one second element selected from the group consisting of alkali metal elements and alkaline earth metal elements. In providing a second flux, the second element is preferably at least one selected from the group consisting of Li, Na, K, Rb, Cs, Be, Mg, Ca, Sr, and Ba. Specific examples of the compound containing the second element include carbonates and halides containing the second element. The compound containing the second element contained in the second flux is preferably at least one selected from the group consisting of Li₂CO₃, Na₂CO₃, K₂CO₃, Rb₂CO₃, Cs₂CO₃, MgO, MgCO₃, CaCO₃, SrCO₃, BaCO₃, LiF, NaF, KF, RbF, BeF₂, MgF₂, CaF₂, SrF₂, BaF₂, LiCl, NaCl, KCl, MgCl₂, CaCl₂, SrCl₂, and BaCl₂.

The second flux, together with the first flux, facilitates the reaction of the compounds contained in the raw material mixture, and allows the solid-phase reaction to proceed more uniformly. The melting point of the second flux is different from that of the first flux, and the heat treatment together with the first and second fluxes, which have different melting points, can further facilitate the reaction of the compounds contained in the raw material mixture to obtain phosphor particles having a higher light emission intensity. The oxide contained in the first flux is adhered to the surface of the resulting phosphor particles in the form of particles or a film, and the compound containing the second element contained in the second flux may be adhered thereto. There may be the case where the elements contained in the second flux are the same as at least some of the elements constituting the oxide phosphor. When the compound containing the elements constituting the oxide phosphor is the same as the compound used as the second flux, the compound containing the elements is added to the raw material mixture such that the resulting oxide phosphor has a desired composition, to form a crystal structure of the resulting oxide phosphor, and the compound added as the raw material is expected to react with the first flux. Therefore, it is preferable to add, as the second flux, the same compound as that added to the raw material mixture as the raw material.

The method for producing an oxide phosphor includes obtaining a mixture by mixing the raw material mixture, the first flux, and the second flux. In obtaining a mixture, the second flux is preferably added in an amount of 0.01% by mass or more relative to 100% by mass of the raw material mixture. In obtaining a mixture, when the second flux is added in an amount of 0.01 % by mass or more relative to 100% by mass of the raw material mixture, the reaction of the compounds contained in the raw material mixture is facilitated, and phosphor particles having a large particle diameter can be obtained. When the second flux is formed from a compound containing a second element, the compound containing the second element that is the second flux is preferably added in an amount of 0.01 % by mass or more relative to 100% by mass of the raw material mixture. The amount of the second flux added may be 0.05% by mass or more, or may be 0.1% by mass or more, relative to 100% by mass of the raw material mixture. The amount of the second flux added may be less than 50% by mass relative to 100% by mass of the raw material mixture. The second flux may be added in any amount necessary to facilitate the reaction of the raw material mixture and may be added in an amount of 30% by mass or less, 20% by mass or less, or 10% by mass or less, relative to 100% by mass of the raw material mixture.

In obtaining a mixture, the amount (% by mass) of the first flux added relative to 100% by mass of the raw material mixture is preferably 1.5 times or more the amount (% by mass) of the second flux added. When the amount of the first flux added is 1.5 times or more the amount of the second flux added, the reaction of the compounds contained in the raw material mixture is further facilitated, so that phosphor particles having a higher light emission intensity can be obtained. In obtaining a mixture, the amount (% by mass) of the first flux added relative to 100% by mass of the raw material mixture is more preferably 1.75 times or more the amount (% by mass) of the second flux added, and may be 10 times or less, 7.5 times or less, or 5 times or less.

In obtaining a mixture, the raw material mixture and the first flux, or the raw material mixture, the first flux, and the second flux, may be mixed using a mixing machine. As the mixing machine, for example, a ball mill, a vibration mill, a roll mill, and a jet mill, which are commonly used in industry, can be used.

The method for producing an oxide phosphor includes obtaining an oxide phosphor containing phosphor particles and first compound particles containing a first element and disposed on the surface of the phosphor particles by heat-treating the mixture.

The method for producing an oxide phosphor includes obtaining an oxide phosphor containing phosphor particles, first compound particles containing a first element and disposed on the surface of the phosphor particles, and second compound particles containing a second element and disposed on the surface of the phosphor particles by heat-treating the mixture.

The resulting mixture can be positioned in a crucible or a boat formed of a material such as graphite or other carbon, boron nitride (BN), alumina (Al₂O₃), tungsten (W), or molybdenum (Mo), and heat-treated in a furnace.

In obtaining an oxide phosphor, the temperature of the heat treatment is preferably 1,000 °C or higher and 1,700 °C or lower, more preferably 1,100 °C or higher and 1,600 °C or lower, and even more preferably 1,300 °C or higher and 1,550 °C or lower. When the temperature of the heat treatment is 1,000 °C or higher and 1,700 °C or lower, the oxide phosphor can be inhibited from decomposition by heat, and thus can have a desired composition and a stable crystal structure.

The heat treatment is preferably performed in an atmosphere containing oxygen. Any appropriate content of oxygen can be contained in the atmosphere. The content of oxygen in the atmosphere containing oxygen is preferably 5% by volume or more, more preferably 10% by volume or more, and even more preferably 15% by volume or more. The heat treatment is preferably performed in an air atmosphere (oxygen content of 20% by volume or more). If the atmosphere does not contain oxygen, e.g., if an oxygen content is less than 1% by volume, there may be a case in which an oxide phosphor having a desired composition is not obtained.

In the heat treatment, a maintaining time at a predetermined temperature may be set. The maintaining time may be, for example, 0.5 hour or more and 48 hours or less, may be 1 hour or more and 40 hours or less, or may be 2 hours or more and 30 hours or less. By setting the maintaining time in the range of 0.5 hour or more and 48 hours or less, the crystal growth can be facilitated.

The pressure in the heat treatment atmosphere may be standard atmospheric pressure (0.101 MPa) and may be 0.101 MPa or more; and the heat treatment may be performed in a pressurized atmosphere range of 0.11 MPa or more and 200 MPa or less. In the heat-treated product obtained by the heat treatment, the crystal structure is more easily decomposed at a higher heat treatment temperature, but in a pressurized atmosphere, the decomposition of the crystal structure can be inhibited.

The heat treatment time can be appropriately selected depending on the heat treatment temperature and the pressure of the atmosphere during the heat treatment and is preferably 0.5 hour or more and 20 hours or less. Even in the case of performing two or more stages of heat treatment, the time for one heat treatment is preferably 0.5 hour or more and 20 hours or less. With the heat treatment time of 0.5 hour or more and 20 hours or less, the decomposition of the heat-treated product obtained is inhibited, and a phosphor having a stable crystal structure, and a desired light emission intensity can be obtained. In addition, the production cost can be reduced, and the production time can be relatively shortened. The heat treatment time is more preferably 1 hour or more and 10 hours or less, and even more preferably 1.5 hours or more and 9 hours or less.

In obtaining an oxide phosphor, it is preferred that the phosphor particles obtained have any one of a composition represented by the formula (1), a composition represented by the formula (2), or a composition represented by the formula (3).

The heat-treated product obtained by the heat treatment may be subjected to posttreatments such as pulverization, dispersion, solid-liquid separation, and drying. The solid-liquid separation may be performed by a method used industrially, such as filtration, suction filtration, pressure filtration, centrifugal separation, and decantation. The drying may be performed with an apparatus used industrially, such as a vacuum dryer, a hot air dryer, a conical dryer, and a rotary evaporator.

### EXAMPLES

The present disclosure will be more specifically described with reference to the following Examples. The present invention is not limited to the following Examples.

The oxide phosphors according to Examples and Comparative Examples were subjected to the following evaluations. The results are shown in each Table.

### Measurements of Light Emission Spectrum, Light Emission Peak Wavelength, Full Width at Half Maximum (FWHM), and Relative Light Emission Intensity

For the oxide phosphor according to each of Examples and Comparative Examples, the light emission spectrum was measured using a quantum efficiency measurement system (QE-2000, manufactured by Otsuka Electronics Co., Ltd.). The light emission peak wavelength of the excitation light of the light emitting element, which is a semiconductor element, used in the quantum efficiency measurement system was 450 nm. From the obtained light emission spectrum of each phosphor, the relative light emission intensity, light emission peak wavelength, and full width at half maximum were determined as light emission characteristics. Specifically, the light emission peak wavelength (nm) in the light emission spectrum of each phosphor and the full width at half maximum (FWHM) (nm) in the light emission spectrum were determined. For the oxide phosphors according to Examples 1 to 28, the relative light emission intensity (%) was determined relative to the light emission intensity at the light emission peak wavelength of the oxide phosphor according to Comparative Example 1 being 100%. For the oxide phosphors according to Examples 29 to 31, the relative light emission intensity (%) was determined relative to the light emission intensity at the light emission peak wavelength of the oxide phosphor according to Comparative Example 2 being 100%. For the oxide phosphor according to Example 32, the relative light emission intensity (%) was determined relative to the light emission intensity at the light emission peak wavelength of the oxide phosphor according to Comparative Example 3 being 100%. For the oxide phosphor according to Example 33, the relative light emission intensity (%) was determined relative to the light emission intensity at the light emission peak wavelength of the oxide phosphor according to Comparative Example 4 being 100%. For the oxide phosphor according to Example 34, the relative light emission intensity (%) was determined relative to the light emission intensity at the light emission peak wavelength of the oxide phosphor according to Comparative Example 5 being 100%. For the oxide phosphor according to Example 35, the relative light emission intensity (%) was determined relative to the light emission intensity at the light emission peak wavelength of the oxide phosphor according to Comparative Example 6 being 100%. For the oxide phosphor according to Example 36, the relative light emission intensity (%) was determined relative to the light emission intensity at the light emission peak wavelength of the oxide phosphor according to Comparative Example 7 being 100%. The results are shown in each Table. The light emission spectrum of the oxide phosphor according to each of Examples and Comparison Examples is shown in each figure.

### Amount of First Element and Amount of Second Element (% by mass)

Each oxide phosphor containing first compound particles and/or second compound particles was totally dissolved in a mixed solution of sulfuric acid and nitric acid, and then the amounts (% by mass) of elements derived from the phosphor particles, a first element derived from the first compound particles, and/or a second element derived from the second compound particles were calculated by ICP-AES analysis using an inductively coupled plasma-atomic emission spectroscope (ICP-AES, manufactured by PerkinElmer Inc.). Specifically, the amounts of the elements derived from the phosphor particles, a first element derived from the first compound particles, and a second element derived from the second compound particles were measured by ICP-AES analysis. The total amount of the elements derived from the phosphor particles, the first element derived from the first compound particle, and the second element derived from the second compound particle was defined as the total amount of elements derived from the oxide phosphor being 100% by mass. The amount (% by mass) of the first element derived from the first compound particles and the amount (% by mass) of the second element derived from the second compound particles were calculated relative to the total amount of the elements derived from the oxide phosphor being 100% by mass. In the oxide phosphors according to Examples, there was no element that was identical among the elements derived from the phosphor particles, the first element derived from the first compound particles, and the second element derived from the second compound particles. The amount (% by mass) of the first element derived from the first compound particles and the amount (% by mass) of the second element derived from the second compound particles were calculated relative to the total amount of the elements derived from the oxide phosphor being 100% by mass.

### Observation of Oxide Phosphor

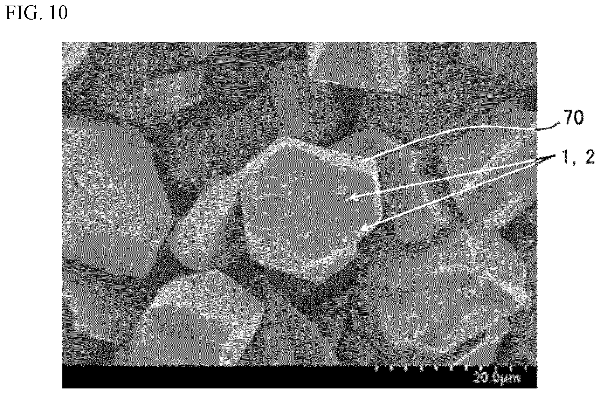

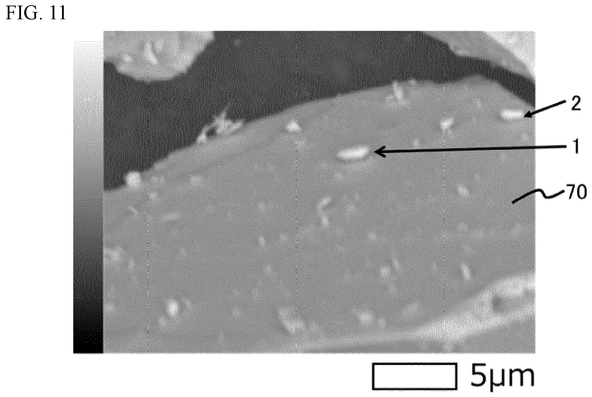

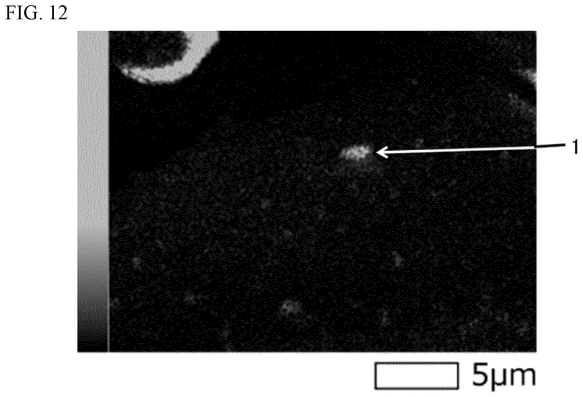

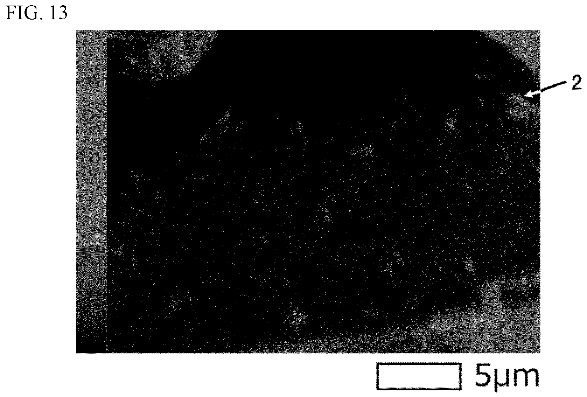

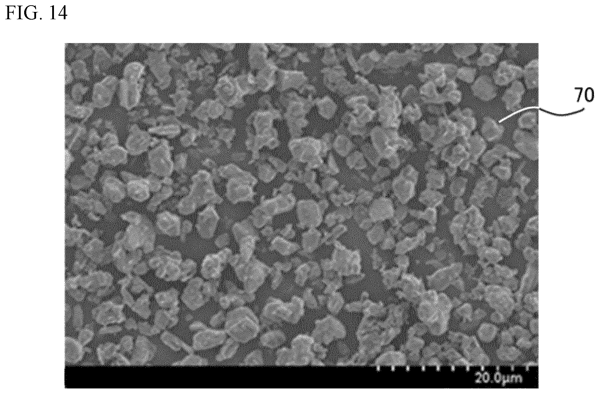

The oxide phosphors were observed using an SEM-EDX system (model number SU8230, manufactured by Shimadzu Corporation, and a silicon drift detector, manufactured by HORIBA, Ltd.). FIG. 10 is an SEM micrograph of the oxide phosphor according to Example 1. FIG. 11 is an SEM micrograph of the surface of the oxide phosphor according to Example 4. FIG. 12 is an SEM micrograph, as obtained by EDX analysis of the surface of the oxide phosphor according to Example 4, showing the distribution of a first element (Nb) contained in oxide particles. FIG. 13 is an SEM micrograph, as obtained by EDX analysis of the surface of the oxide phosphor according to Example 4, showing the distribution of a second element (Na) contained in second compound particles. FIG. 14 is an SEM micrograph of the oxide phosphor according to Comparative Example 1.

### Volume Average Particle Diameter

For the oxide phosphors according to Examples and Comparative Examples, the volume average particle diameter in which the cumulative frequency from the small diameter side was 50% in the volume-based particle size distribution was measured using a laser diffraction particle size distribution measurement apparatus (Mastersizer 2000, manufactured by Malvern Panalytical Ltd.).

### X-Ray Diffraction Pattern and Peak Intensity

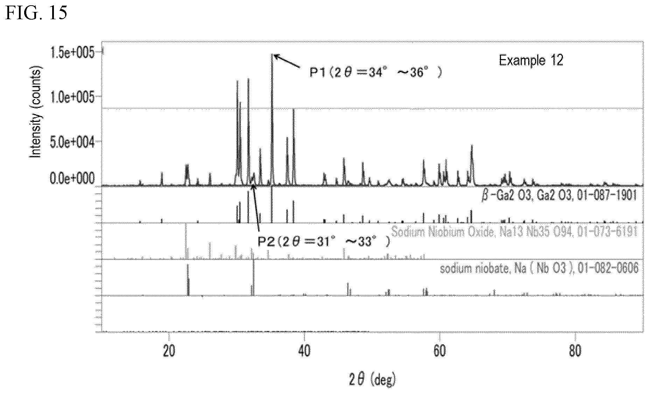

For the oxide phosphor according to Example 12, the X-ray diffraction pattern was measured using a horizontal sample type multipurpose X-ray diffraction system (Ultima IV, manufactured by Rigaku Corporation) with an X-ray source of CuKα rays (λ = 1.5418 Å, tube voltage of 40 kV, and tube current of 40 mA). In the X-ray diffraction pattern of the oxide phosphor according to Example 12, the intensity ratio P1/P2 of the intensity of the first peak P1 having the highest intensity within the range of the Bragg angles 2θ of 34°to 36°, inclusive, to the second peak P2 having the lowest intensity among the intensities of peak tops within the range of the Bragg angles 2θ of 31° to 33°, inclusive, was determined. FIG. 15 shows an X-ray diffraction pattern of the oxide phosphor according to Example 12 and powder X-ray diffraction patterns indicating the crystal structures of β-Ga₂O₃, Na₁₃Nb₃₅O₉₄, and Na(NbO₃). The powder X-ray diffraction patterns indicating the crystal structures of β-Ga₂O₃, Na₁₃Nb₃₅O₉₄, and Na(NbO₃) can be referred to the values of the International Center for Diffraction Data (ICDD).

### Example 1

A raw material mixture was provided using 18.8 g of Ga₂O₃ and 0.23 g of Cr₂O₃ as raw materials (to obtain a target composition of Ga₂O₃:Cr_{0.03}). 2.01 g of Nb₂O₅ (10.5% by mass relative to 100% by mass of the raw material mixture) was provided as a first flux, and 0.54 g of Na₂CO₃ (2.8% by mass relative to 100% by mass of the raw material mixture) was provided as a second flux. The raw material mixture, the first flux, and the second flux were mixed using an agate mortar and an agate pestle for approximately 10 minutes to obtain a mixture.

The resulting mixture was placed in an alumina crucible and heat-treated at 1,400 °C for 8 hours in an air atmosphere (20% by volume of oxygen) with standard atmospheric pressure (0.101 MPa).

After the heat treatment, the resulting heat-treated product was pulverized to obtain an oxide phosphor according to Example 1 having the composition shown in Table 1 with the molar ratios of the target composition. The phosphor particles according to Example 1 and the phosphor particles according to Examples 2 to 28 described below each had the composition represented by the formula (1), wherein the parameter v1 in the formula (1) was 0 (v1 = 0) and x1 was 0.03 (x1 = 0.03). The oxide phosphor according to Example 1 had a volume average particle diameter at 50% cumulative in the volume-based particle size distribution, as measured by the laser diffraction particle size distribution measurement method, of 20.3 µm.

### Example 2

An oxide phosphor according to Example 2 was obtained in the same or similar manner as in Example 1, except that 0.4 g of Na₂CO₃ (2.1% by mass relative to 100% by mass of the raw material mixture) was provided as a second flux.

### Example 3

An oxide phosphor according to Example 3 was obtained in the same or similar manner as in Example 1, except that 0.27 g of Na₂CO₃ (1.4% by mass relative to 100% by mass of the raw material mixture) was provided as a second flux.

### Example 4

An oxide phosphor according to Example 4 was obtained in the same or similar manner as in Example 1, except that 1.34 g of Nb₂O₅ (7.0% by mass relative to 100% by mass of the raw material mixture) was provided as a first flux, and 0.27 g of Na₂CO₃ (1.4% by mass relative to 100% by mass of the raw material mixture) was provided as a second flux. The oxide phosphor according to Example 4 had a volume average particle diameter at 50% cumulative in the volume-based particle size distribution, as measured by the laser diffraction particle size distribution measurement method, of 19.4 µm. The oxide phosphor according to Example 4 had an amount of Nb, which is the first element contained in the first compound particles, of 1.5% by mass and an amount of Na, which is the second element contained in the second compound particles, of 0.16% by mass, relative to 100% by mass of the oxide phosphor, as measured using the ICP-AES analyzer.

### Example 5

An oxide phosphor according to Example 5 was obtained in the same or similar manner as in Example 1, except that 1.34 g of Nb₂O₅ (7.0% by mass relative to 100% by mass of the raw material mixture) was provided as a first flux, and 0.19 g of Na₂CO₃ (1.0% by mass relative to 100% by mass of the raw material mixture) was provided as a second flux.

### Example 6

An oxide phosphor according to Example 6 was obtained in the same or similar manner as in Example 1, except that 1.34 g of Nb₂O₅ (7.0% by mass relative to 100% by mass of the raw material mixture) was provided as a first flux, and 0.27 g of Li₂CO₃ (1.4% by mass relative to 100% by mass of the raw material mixture) was provided as a second flux.

### Example 7

An oxide phosphor according to Example 7 was obtained in the same or similar manner as in Example 1, except that 1.34 g of Nb₂O₅ (7.0% by mass relative to 100% by mass of the raw material mixture) was provided as a first flux, and 0.27 g of K₂CO₃ (1.4% by mass relative to 100% by mass of the raw material mixture) was provided as a second flux.

### Example 8

An oxide phosphor according to Example 8 was obtained in the same or similar manner as in Example 1, except that 1.34 g of Nb₂O₅ (7.0% by mass relative to 100% by mass of the raw material mixture) was provided as a first flux, and 0.27 g of Rb₂CO₃ (1.4% by mass relative to 100% by mass of the raw material mixture) was provided as a second flux.

### Example 9

An oxide phosphor according to Example 9 was obtained in the same or similar manner as in Example 1, except that 1.34 g of Nb₂O₅ (7.0% by mass relative to 100% by mass of the raw material mixture) was provided as a first flux, and 0.27 g of SrCO₃ (1.4% by mass relative to 100% by mass of the raw material mixture) was provided as a second flux. The oxide phosphor according to Example 9 had an amount of Nb, which is the first element contained in the first compound particles, of 1.1% by mass and an amount of Sr, which is the second element contained in the second compound particles, of 0.05% by mass, relative to 100% by mass of the oxide phosphor, as measured using the ICP-AES analyzer.

### Example 10

An oxide phosphor according to Example 10 was obtained in the same or similar manner as in Example 1, except that 1.34 g of Nb₂O₅ (7.0% by mass relative to 100% by mass of the raw material mixture) was provided as a first flux, and 0.27 g of BaCO₃ (1.4% by mass relative to 100% by mass of the raw material mixture) was provided as a second flux.

### Example 11

An oxide phosphor according to Example 11 was obtained in the same or similar manner as in Example 1, except that 1.34 g of Nb₂O₅ (7.0% by mass relative to 100% by mass of the raw material mixture) was provided as a first flux, and no second flux was provided. The oxide phosphor according to Example 11 had an amount of Nb, which is the first element contained in the first compound particles of 4.5% by mass relative to 100% by mass of the oxide phosphor, as measured using the ICP-AES analyzer.

### Example 12

An oxide phosphor according to Example 12 was obtained in the same or similar manner as in Example 1, except that 13.4 g of Nb₂O₅ (70.0% by mass relative to 100% by mass of the raw material mixture) was provided as a first flux, 2.7 g of Na₂CO₃ (14.0% by mass relative to 100% by mass of the raw material mixture) was provided as a second flux, and the temperature of the heat treatment was set to 1,250 °C.

### Example 13

An oxide phosphor according to Example 13 was obtained in the same or similar manner as in Example 1, except that 1.34 g of Ta₂O₅ (7.0% by mass relative to 100% by mass of the raw material mixture) was provided as a first flux, and 0.27 g of Na₂CO₃ (1.4% by mass relative to 100% by mass of the raw material mixture) was provided as a second flux.

### Example 14

An oxide phosphor according to Example 14 was obtained in the same or similar manner as in Example 13, except that 1.34 g of diammonium hydrogen phosphate (NH₄)₂HPO₄ (7.0% by mass relative to 100% by mass of the raw material mixture) was provided as a first flux.

### Example 15

An oxide phosphor according to Example 15 was obtained in the same or similar manner as in Example 13, except that 1.34 g of GeO₂ (7.0% by mass relative to 100% by mass of the raw material mixture) was provided as a first flux.

### Example 16

An oxide phosphor according to Example 16 was obtained in the same or similar manner as in Example 13, except that 1.34 g of ZrO₂ (7.0% by mass relative to 100% by mass of the raw material mixture) was provided as a first flux.

### Example 17

An oxide phosphor according to Example 17 was obtained in the same or similar manner as in Example 13, except that 1.34 g of HfO₂ (7.0% by mass relative to 100% by mass of the raw material mixture) was provided as a first flux.

### Example 18

An oxide phosphor according to Example 18 was obtained in the same or similar manner as in Example 13, except that 1.34 g of SiO₂ (7.0% by mass relative to 100% by mass of the raw material mixture) was provided as a first flux.

### Example 19

An oxide phosphor according to Example 19 was obtained in the same or similar manner as in Example 1, except that 1.34 g of Nb₂O₅ (7.0% by mass relative to 100% by mass of the raw material mixture) was provided as a first flux, and 0.21 g of NaF (1.1% by mass relative to 100% by mass of the raw material mixture) was provided as a second flux.

### Example 20

An oxide phosphor according to Example 20 was obtained in the same or similar manner as in Example 19, except that 0.12 g of LiF (0.6% by mass relative to 100% by mass of the raw material mixture) was provided as a second flux.

### Example 21

An oxide phosphor according to Example 21 was obtained in the same or similar manner as in Example 1, except that 0.67 g of Nb₂O₅ (3.5% by mass relative to 100% by mass of the raw material mixture) was provided as a first flux, and 0.23 g of SrCO₃ (1.2% by mass relative to 100% by mass of the raw material mixture) was provided as a second flux.

### Example 22

An oxide phosphor according to Example 22 was obtained in the same or similar manner as in Example 1, except that 0.67 g of Nb₂O₅ (3.5% by mass relative to 100% by mass of the raw material mixture) was provided as a first flux, and 0.32 g of SrCO₃ (1.7% by mass relative to 100% by mass of the raw material mixture) was provided as a second flux.

### Example 23

An oxide phosphor according to Example 23 was obtained in the same or similar manner as in Example 1, except that 0.67 g of Nb₂O₅ (3.5% by mass relative to 100% by mass of the raw material mixture) was provided as a first flux, and 0.38 g of SrCO₃ (2.0% by mass relative to 100% by mass of the raw material mixture) was provided as a second flux.

### Example 24

An oxide phosphor according to Example 24 was obtained in the same or similar manner as in Example 1, except that 0.67 g of Nb₂O₅ (3.5% by mass relative to 100% by mass of the raw material mixture) was provided as a first flux, and 0.67 g of SrCO₃ (3.5% by mass relative to 100% by mass of the raw material mixture) was provided as a second flux.

### Example 25

An oxide phosphor according to Example 25 was obtained in the same or similar manner as in Example 1, except that 0.33 g of Nb₂O₅ (1.7% by mass relative to 100% by mass of the raw material mixture) was provided as a first flux, and 0.19 g of SrCO₃ (1.0% by mass relative to 100% by mass of the raw material mixture) was provided as a second flux.

### Example 26

An oxide phosphor according to Example 26 was obtained in the same or similar manner as in Example 1, except that 1.0 g of Nb₂O₅ (5.3% by mass relative to 100% by mass of the raw material mixture) was provided as a first flux, and 0.57 g of SrCO₃ (3.0% by mass relative to 100% by mass of the raw material mixture) was provided as a second flux.

### Example 27

An oxide phosphor according to Example 27 was obtained in the same or similar manner as in Example 1, except that 1.34 g of Nb₂O₅ (7.0% by mass relative to 100% by mass of the raw material mixture) was provided as a first flux, and 0.76 g of SrCO₃ (4.0% by mass relative to 100% by mass of the raw material mixture) was provided as a second flux. The oxide phosphor according to Example 27 had a volume average particle diameter at 50% cumulative in the volume-based particle size distribution, as measured by the laser diffraction particle size distribution measurement method, of 22.7 µm.

### Example 28

An oxide phosphor according to Example 28 was obtained in the same or similar manner as in Example 1, except that 1.67 g of Nb₂O₅ (8.8% by mass relative to 100% by mass of the raw material mixture) was provided as a first flux, and 0.95 g of SrCO₃ (5.0% by mass relative to 100% by mass of the raw material mixture) was provided as a second flux.

### Comparative Example 1

An oxide phosphor according to Comparative Example 1 was obtained in the same or similar manner as in Example 1, except that the first flux and the second flux were not used, and 0.10 g of H₃BO₃ (0.5% by mass relative to 100% by mass of the raw material mixture) was provided as a flux. The phosphor particles according to Comparative Example 1 had the composition represented by the formula (1), wherein the parameter v1 in the formula (1) was 0 (v1 = 0) and x1 was 0.03 (x1 = 0.03). The oxide phosphor according to Comparative Example 1 had a volume average particle diameter at 50% cumulative in the volume-based particle size distribution, as measured by the laser diffraction particle size distribution measurement method, of 4.1 µm.

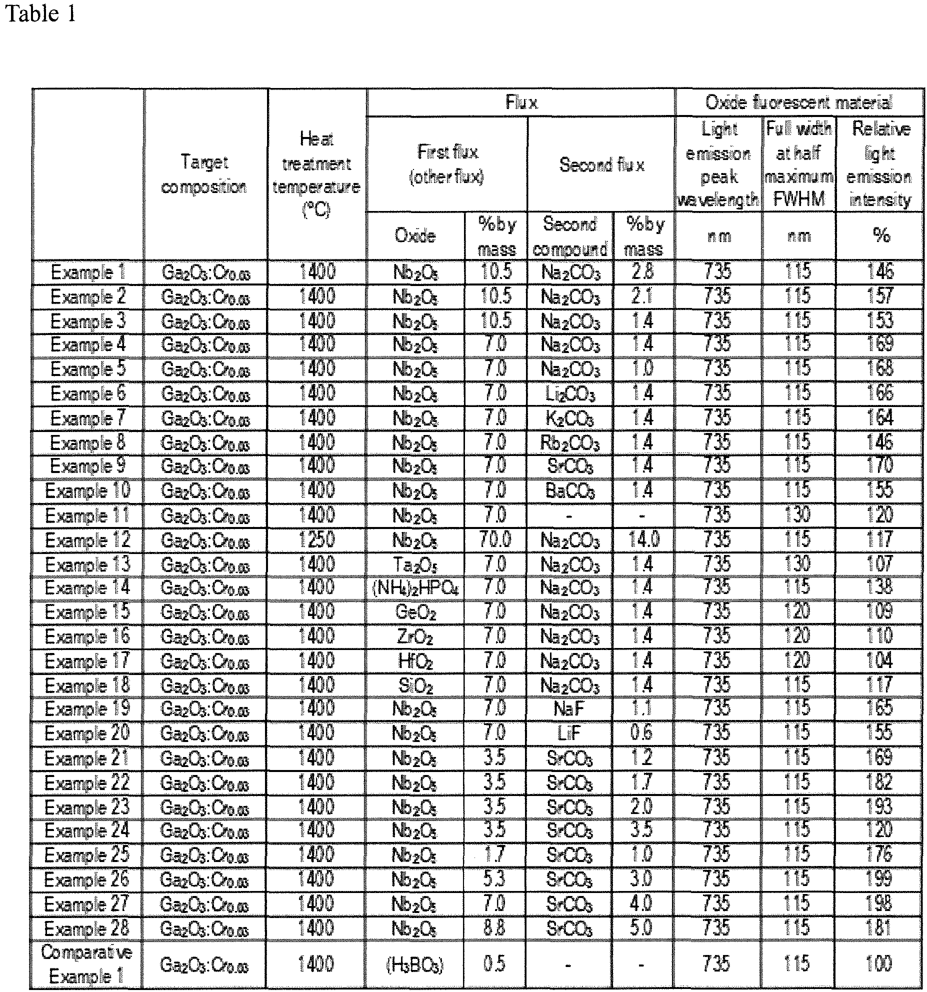

Each of the oxide phosphors according to Examples 1 to 28 had been heat-treated together with the first flux and/or the second flux, and thus exhibited a light emission intensity higher than that of the oxide phosphor according to Comparative Example 1, which had been heat-treated together with the flux different from the first flux and/or the second flux.

The oxide phosphor according to Example 12 had a higher light emission intensity than that of the oxide phosphor according to Comparative Example 1, even though the masses of the first flux and the second flux were increased and the temperature of the heat treatment was lowered to 1,250 °C.

The volume average particle diameter of the oxide phosphor according to Example 1 was 20.3 µm, the volume average particle diameter of the oxide phosphor according to Example 4 was 19.4 µm, and the volume average particle diameter of the oxide phosphor according to Comparative Example 1 was 4.1 µm. Each of the oxide phosphors according to Examples 1 and 4 had a larger volume average particle diameter than that of the oxide phosphor according to Comparative Example 1, which was heat-treated together with the flux different from the first flux and/or the second flux.

In the oxide phosphor according to Example 4, an amount of Nb, which is the first element contained in the first compound particles, was 1.5% by mass, and an amount of Na, which is the second element contained in the second compound particles, was 0.16% by mass, relative to 100% by mass of the oxide phosphor, as measured using the ICP-AES analyzer. In the oxide phosphor according to Example 9, an amount of Nb, which is the first element contained in the first compound particles, was 1.1% by mass, and an amount of Sr, which is the second element contained in the second compound particles, was 0.05% by mass, relative to 100% by mass of the oxide phosphor, as measured using the ICP-AES analyzer. In the oxide phosphor according to Example 11, an amount of Nb, which is the first element contained in the first compound particles, was 4.5% by mass relative to 100% by mass of the oxide phosphor, as measured using the ICP-AES analyzer. In each of the oxide phosphors according to Examples 4, 9, and 11, an amount of the first element contained in the first compound particles was 0.05% by mass or more and 100% by mass or less relative to 100% by mass of the oxide phosphor. In each of the oxide phosphors according to Examples 4 and 9, an amount of the second element contained in the second compound particles was 0.01% by mass or more and 100% by mass or less relative to 100% by mass of the oxide phosphor.

Each of the oxide phosphors according to Examples 21 to 24 had been heat-treating together with the first flux and the second flux, and thus had a high relative light emission intensity. In each of the oxide phosphors according to Examples 21 to 23, the amount of the first flux was larger than that of the second flux, relative to 100% by mass of the raw material mixture, and the amount of the first element was presumed to be larger than that of the second element. In the oxide phosphor according to Example 24, the amount of the first flux was smaller than that of the second flux, relative to 100% by mass of the raw material mixture, and the amount of the first element was presumed to be smaller than that of the second element. Each of the oxide phosphors according to Examples 21 to 23 had a higher relative light emission intensity than that of the oxide phosphor according to Example 24, indicating that the relative light emission intensity was higher when the amount of the first element was larger than that of the second element.

Each of the oxide phosphors according to Examples 25 to 28 had been heat-treated together with the first flux and the second flux, and thus had a high relative light emission intensity. A ratio of the amount of the first flux to the amount of the second flux relative to 100% by mass of the raw material mixture in each of the oxide phosphors according to Examples 25 to 28 was in a range of 1.7 to 1.76 : 1 (first flux : second flux), and thus was approximately the same among Examples 25 to 28. However, the relative light emission intensity of the oxide phosphors according to Examples 26 and 27 was higher than those of the oxide phosphors according to Examples 25 and 28. The oxide phosphor obtained exhibited a higher light emission intensity when the total amount of the first flux and the second flux was 5% by mass or more and 12% by mass or less relative to 100% by mass of the raw material mixture.

The oxide phosphor according to Example 26 had a volume average particle diameter of 22.7 µm, which was larger than that of the oxide phosphor according to Comparative Example 1 that had been heat-treated together with the flux different from the first flux and/or the second flux.

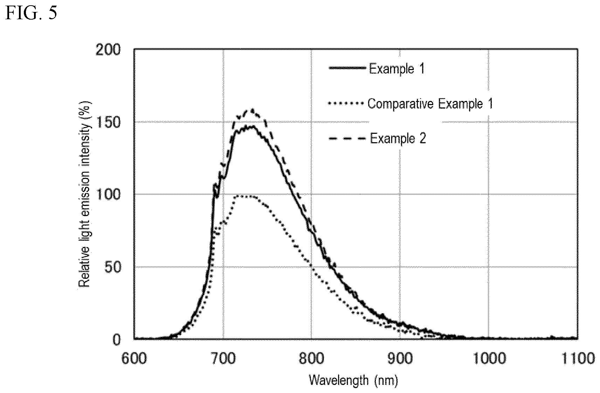

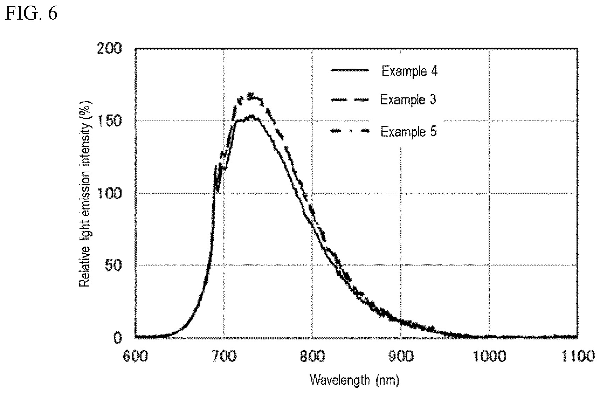

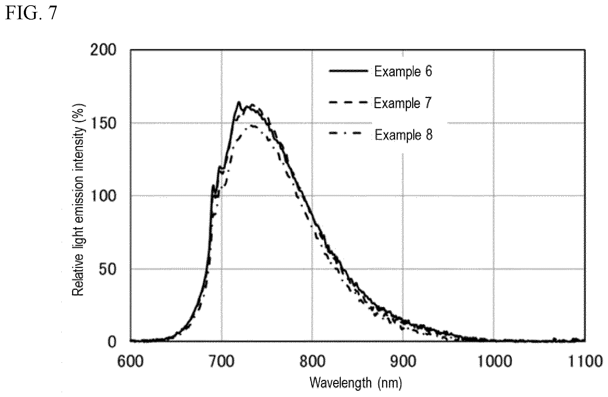

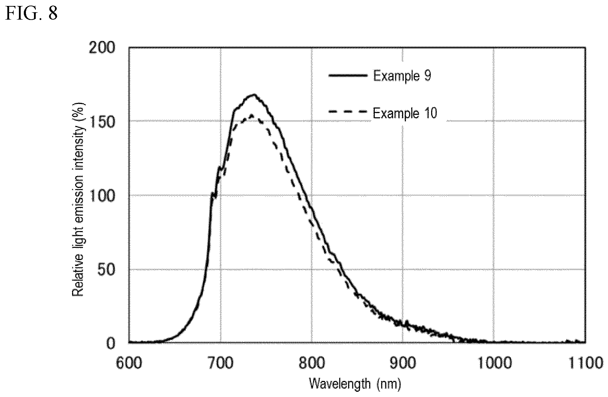

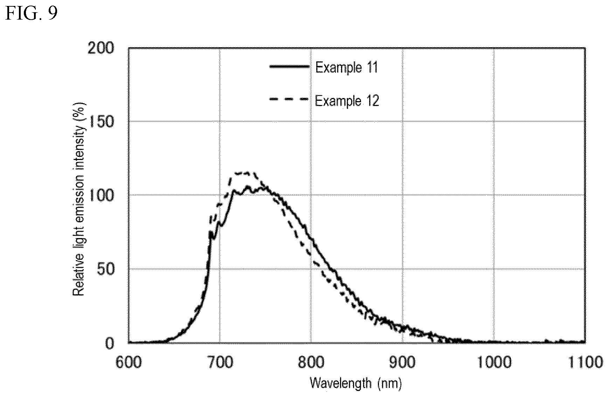

As shown in FIGS. 5 to 9, the light emission peak wavelengths of the light emission spectra in the oxide phosphors according to Examples 1 to 12 were the same as or like the light emission peak wavelength of the light emission spectrum in the oxide phosphor according to Comparative Example 1. The relative light emission intensities at the light emission peak wavelengths in the light emission spectra of the oxide phosphors according to Examples 1 to 12 were 100% or more, which were higher than the light emission intensity at the light emission peak wavelength in the light emission spectrum of the oxide phosphor according to Comparative Example 1.

FIG. 10 is an SEM micrograph of the oxide phosphor according to Example 1. As shown in the SEM micrograph of the oxide phosphor according to Example 1, it was observed that the first compound particles 1 and/or the second compound particles 2 were adhered to the surface of the phosphor particles of the phosphor 70, which is the oxide phosphor.

FIG. 11 is an SEM micrograph of the surface of the oxide phosphor according to Example 4. FIG. 12 is an SEM micrograph, as obtained by EDX analysis of the surface of the oxide phosphor according to Example 4, showing the distribution of the first element (Nb) contained in the oxide particles. FIG. 13 is an SEM micrograph, as obtained by EDX analysis of the surface of the oxide phosphor according to Example 4, showing the distribution of the second element (Na) contained in the second compound particles. As shown in FIGS. 11 to 13, it was observed that the first compound particles 1 containing the oxide particles containing Nb, which is the first element contained in the first flux, and the second compound particles 2 containing Na, which is the second element contained in the second flux, were on the surface of the phosphor 70, which is the oxide phosphor.

FIG. 14 is an SEM micrograph of the oxide phosphor according to Comparative Example 1. The oxide phosphor according to Comparative Example 1 was formed using boric acid (H₃BO₃) as a flux different from the first flux and the second flux, without using the first flux and/or the second flux. In the oxide phosphor according to Comparative Example 1, the phosphor particles of the phosphor 70, which is the oxide phosphor, were not formed as large crystals in contrast to the oxide phosphor according to Example 1, and the first compound particles and the second compound particles were not observed on the surfaces of the oxide phosphor particles of the phosphor 70.

FIG. 15 shows an X-ray diffraction pattern of the oxide phosphor according to Example 12. The phosphor particles according to Example 12 had the composition represented by the formula (1-1), wherein x1 in the formula (1-1) was 0.03 (x1 = 0.03). The X-ray diffraction pattern of the oxide phosphor according to Example 12 shown in FIG. 15 had peaks at the same positions as those in the powder X-ray diffraction patterns of gallium oxide (Ga₂O₃) and sodium and niobium oxides (Na₁₃Nb₃₅O₉₄ and Na(NbO₃)), indicating that the oxide phosphor had a crystal structure of gallium oxide and contained first compound particles composed of niobium oxide and second compound particles containing Na as a second element. In the X-ray diffraction pattern of the oxide phosphor according to Example 12 shown in FIG. 15, the peak intensity ratio (P1/P2) of the intensity of the first peak P1, which is a peak top having an intensity that is the highest within a range of the Bragg angle 2θ of 34° to 36°, inclusive, to the second peak P2, which is a peak top having an intensity lowest among intensities of peak tops within a range of the Bragg angle 2θ of 31° to 33°, inclusive, was 14.

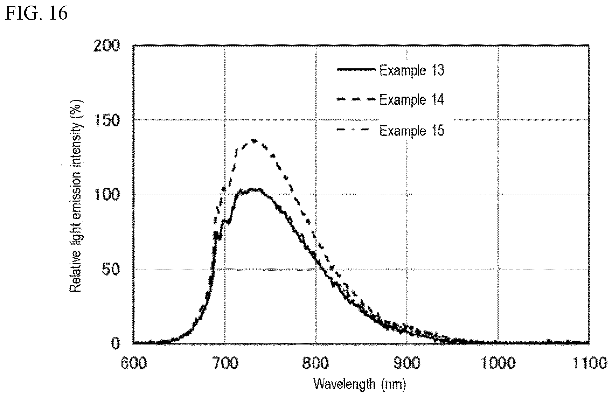

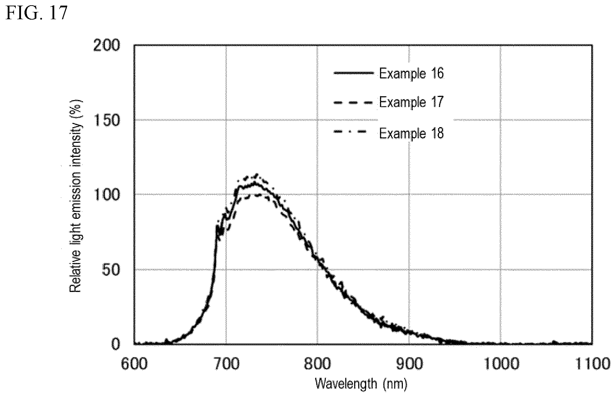

As shown in FIGS. 16 and 17, the light emission peak wavelengths in the light emission spectra of the oxide phosphors according to Examples 13 to 18 were at approximately the same position.

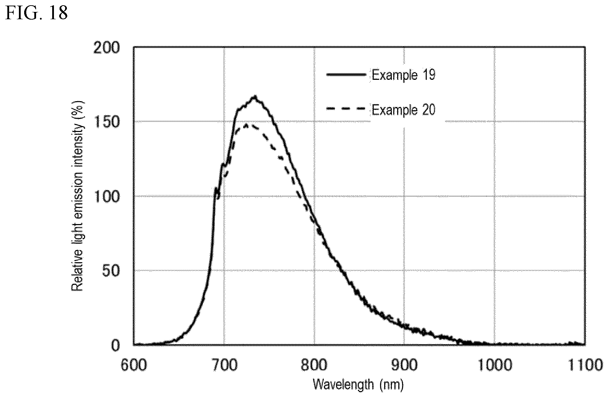

As shown in FIG. 18, the light emission peak wavelengths in the light emission spectra of the oxide phosphors according to Examples 19 and 20 were at approximately the same position.

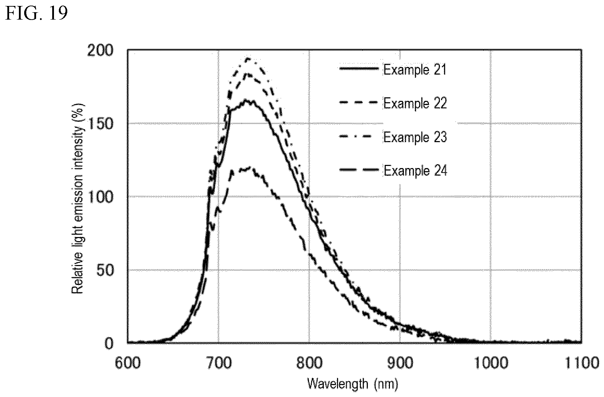

As shown in FIG. 19, the light emission peak wavelengths in the light emission spectra of the oxide phosphors according to Examples 21 to 24 were at approximately the same position.

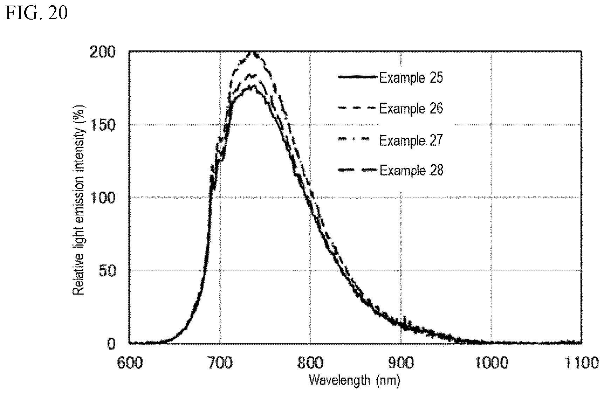

As shown in FIG. 20, the light emission peak wavelengths in the light emission spectra of the oxide phosphors according to Examples 25 to 28 were at approximately the same position.

### Example 29

A raw material mixture was provided using 16.9 g of Ga₂O₃, 2.78 g of In₂O₃, and 0.31 g of Cr₂O₃ as raw materials (to obtain a target composition of (Ga_{0.9}In_{0.1})₂O₃:Cr_{0.04}). Subsequently, 0.11 g of Nb₂O₅ (0.55% by mass relative to 100% by mass of the raw material mixture) was provided as a first flux, and 0.02 g of Na₂CO₃ (0.1% by mass relative to 100% by mass of the raw material mixture) was provided as a second flux. The raw material mixture, the first flux, and the second flux were mixed using an agate mortar and an agate pestle for approximately 10 minutes to obtain a mixture.

The resulting mixture was placed in an alumina crucible and heat-treated at 1,400 °C for 8 hours in an air atmosphere (20% by volume of oxygen) with standard atmospheric pressure (0.101 MPa).

After the heat treatment, the resulting heat-treated product was pulverized to obtain an oxide phosphor according to Example 29 having the composition shown in Table 2 with the molar ratios of the target composition. Each of the phosphor particles according to Examples 29 to 31 had the composition represented by the formula (1), wherein M¹ was In, v1 was 0.1 (v1 = 0.1), and x1 was 0.04 (x1 = 0.04). In the oxide phosphor according to Example 29, an amount of Nb, which is the first element contained in the first compound particles, was 0.20% by mass, and an amount of Na, which is the second element contained in the second compound particles, was 0.02% by mass, relative to 100% by mass of the oxide phosphor, as measured using the ICP-AES analyzer.

### Example 30

An oxide phosphor according to Example 30 was obtained in the same or similar manner as in Example 29, except that 0.02 g of Li₂CO₃ (0.1% by mass relative to 100% by mass of the raw material mixture) was provided as a second flux.

### Example 31

An oxide phosphor according to Example 31 was obtained in the same or similar manner as in Example 29, except that 0.02 g of SrCO₃ (0.1% by mass relative to 100% by mass of the raw material mixture) was provided as a second flux.

### Comparative Example 2

An oxide phosphor according to Comparative Example 2 was obtained in the same or similar manner as in Example 29, except that no flux was used. The phosphor particles according to Comparative Example 2 had the composition represented by the formula (1), wherein M¹ was In, v1 was 0.1 (v1 = 0.1), and x1 was 0.04 (x1 = 0.04).

**Table 2**

| | Target composition | Heat treatment temperature (°C) | Flux | | | | Oxide fuorescent material | | |
|---|---|---|---|---|---|---|---|---|---|
| | | | First flux (other fux) | | Second flux | | Light emission peak wavelength | Full width at half maximum FWHM | Relative light emission intensity |
| | | | Oxide | %by mass | Second compound | %by mass | nm | nm | % |
| Example 29 | (Ga_{0.9}In_{0.1})₂O₃:Cr_{0.04} | 1400 | Nb₂O₅ | 0.55 | Na₂CO₃ | 0.1 | 795 | 135 | 112 |
| Example 30 | (Ga_{0.9}In_{0.1})₂O₃:Cr_{0.04} | 1400 | Nb₂O₅ | 055 | Li₂CO₃ | 0.1 | 795 | 135 | 105 |
| Example 31 | (Ga_{0.9}In_{0.1})₂O₃:Cr_{0.04} | 1400 | Nb₂O₅ | 0.55 | SrCO₃ | 0.1 | 795 | 140 | 106 |
| Comparative Example 2 | (Ga_{0.9}In_{0.1})₂O₃:Cr_{0.04} | 1500 | - | - | - | - | 790 | 140 | 100 |

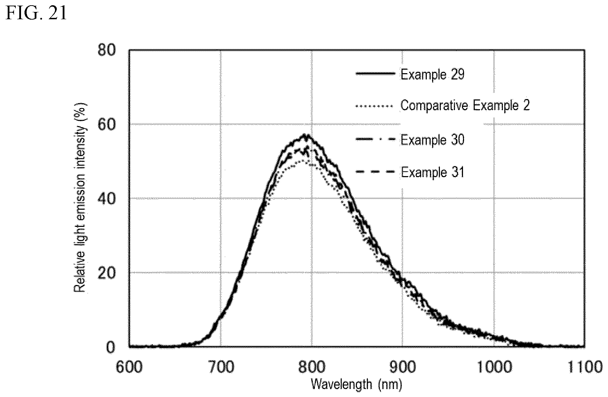

The oxide phosphors according to Examples 29 to 31 each had a higher light emission intensity than that of the oxide phosphor according to Comparative Example 2, which had the same composition and was heat-treated without using the first flux and the second flux. As shown in FIG. 21, although the light emission peak wavelengths in the light emission spectra of the oxide phosphors according to Examples 29 to 31 and the oxide phosphor according to Comparative Example 2 were at approximately the same position, the light emission intensities at the light emission peak wavelengths of the oxide phosphors according to Examples 29 to 31 were higher than the light emission intensity at the light emission peak wavelength of the oxide phosphor according to Comparative Example 2.

In the oxide phosphor according to Example 29, an amount of Nb, which is the first element contained in the first compound particles, was 0.20% by mass, and an amount of Na, which is the second element contained in the second compound particles, was 0.02% by mass, relative to 100% by mass of the oxide phosphor, as measured using the ICP-AES analyzer. The amount of the first element contained in the first compound particles in the oxide phosphor according to Example 29 was 0.05% by mass or more and 100% by mass or less relative to the amount of the oxide phosphor being 100% by mass, and the amount of the second element contained in the second compound particles was 0.01% by mass or more and 100% by mass or less relative to the amount of the oxide phosphor being 100% by mass.

### Example 32

A raw material mixture was provided using 11.7 g of Ga₂O₃, 3.82 g of Al₂O₃, and 0.23 g of Cr₂O₃ as raw materials (to obtain a target composition of (Ga₀.₆₂₅Al_{0.375})₂O₃:Cr_{0.03}). Subsequently, 1.09 g of Nb₂O₅ (7.0% by mass relative to 100% by mass of the raw material mixture) was provided as a first flux, and 0.22 g of Na₂CO₃ (1.4% by mass relative to 100% by mass of the raw material mixture) was provided as a second flux. An oxide phosphor according to Example 32 was obtained in the same or similar manner as in Example 1, except that the resulting raw material mixture, the first flux, and the second flux were used. The oxide phosphor according to Example 32 had the composition represented by the formula (1), wherein M¹ was Al, v1 was 0.375 (v1 = 0.375), and x1 was 0.03 (x1 = 0.03).

### Comparative Example 3

An oxide phosphor according to Comparative Example 3 was obtained in the same or similar manner as in Example 29, except that the first flux and the second flux were not used and 0.08 g of H₃BO₃ (0.5% by mass relative to 100% by mass of the raw material mixture) was provided as a flux. The phosphor particles according to Comparative Example 3 had the composition represented by the formula (1), wherein M¹ was Al, v1 was 0.375 (v1 = 0.375), and x1 was 0.03 (x1 = 0.03).

**Table 3**

| | Target composition | Heat treatment temperature (°C) | Flux | | | | Oxide fluorescent material | | |
|---|---|---|---|---|---|---|---|---|---|
| | | | First flux (other flux) | | Second flux | | Light emission peak wavelength | Full width at half maximum FWHM | Relative light emission intensity |
| | | | Oxide | %by mass | Second compound | %by mass | nm | nm | % |
| Example 32 | (Ga_{.0625}Al_{0.375})₂O₃:Cr_{0.03} | 1400 | Nb₂O₅ | 7.0 | Na₂CO₃ | 1.4 | 715 | 115 | 144 |
| Comparative Example 3 | ((Ga_{.0625}Al_{0.375})₂O₃:Cr_{0.03} | 1400 | (H₃BO₃) | 0.5 | - | - | 715 | 115 | 100 |

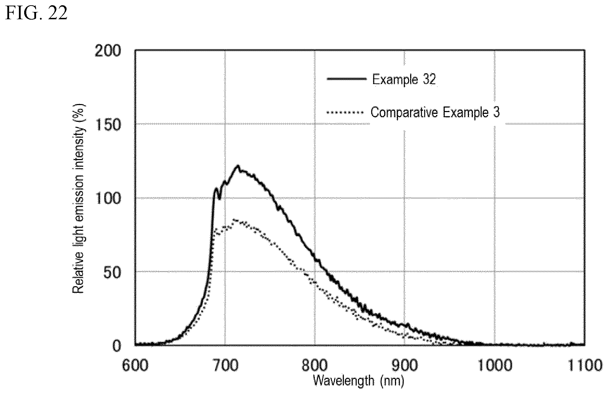

The oxide phosphor according to Example 32 had been heat-treated together with the first flux and/or the second flux, and thus had a larger particle diameter and a higher light emission intensity than those of the oxide phosphor according to Comparative Example 3, which had been heat-treated together with the flux different from the first flux and/or the second flux. As shown in FIG. 22, although the light emission peak wavelengths of the light emission spectra of the oxide phosphor according to Example 32 and the oxide phosphor according to Comparative Example 3 were at approximately the same position, the light emission intensity at the light emission peak wavelength of the oxide phosphor according to Example 32 was higher than the light emission intensity at the light emission peak wavelength of the oxide phosphor according to Comparative Example 3.

### Example 33

A raw material mixture was provided using 3.22 g of MgO, 14.3 g of Ga₂O₃, and 0.55 g of Cr₂O₃ as raw materials (to obtain a target composition of MgGa_{1.91}O₄:Cr_{0.09}). Subsequently, 1.27 g of Nb₂O₅ (7.0% by mass relative to 100% by mass of the raw material mixture) was provided as a first flux, and 0.25 g of Na₂CO₃ (1.4% by mass relative to 100% by mass of the raw material mixture) was provided as a second flux. The raw material mixture, the first flux, and the second flux were mixed using an agate mortar and an agate pestle for approximately 10 minutes to obtain a mixture.

The resulting mixture was placed in an alumina crucible and heat-treated at 1,400 °C for 8 hours in an air atmosphere (20% by volume of oxygen) with standard atmospheric pressure (0.101 MPa).

After the heat treatment, the resulting heat-treated product was pulverized to obtain an oxide phosphor according to Example 33 having the composition shown in Table 4 with the molar ratios of the target composition. The phosphor particles according to Example 33 had the composition represented by the formula (2), wherein t2 was 0 (t2 = 0), u2 was 1.0 (u2 = 1.0), v2 was 0 (v2 = 0), w2 was 4 (w2 = 4), x2 was 0.045 (x2 = 0.045), and y2 was 0 (y2 = 0). In Table 4, in the oxide phosphor according to Example 33, the molar ratio of Cr in 1 mol of the composition of the oxide phosphor was the product of 2 and x2, which was 0.09.

### Comparative Example 4

An oxide phosphor according to Comparative Example 4 was obtained in the same or similar manner as in Example 33, except that no flux was used, and the temperature of the heat treatment was set to 1,500°C. The phosphor particles according to Comparative Example 4 had the composition represented by the formula (2), wherein t2 was 0 (t2 = 0), u2 was 1.0 (u2 = 1.0), v2 was 0 (v2 = 0), w2 was 4 (w2 = 4), x2 was 0.045 (x2 = 0.045), and y2 was 0 (y2 = 0). In Table 4, in the oxide phosphor according to Comparative Example 4, the molar ratio of Cr in 1 mol of the composition of the oxide phosphor was the product of 2 and x2, which was 0.09.

**Table 4**

| | Target compostion | Heat treatment temperature (°C) | Flux | | | | Oxide fluorescent material | | |
|---|---|---|---|---|---|---|---|---|---|
| | | | First flux (other flux) | | Second flux | | Light emission peak wavelength | Full width at half maximum FWHM | Relative light emission intensity |
| | | | Oxide | %by mass | Second compound | %by mass | nm | nm | % |
| Example 33 | MgGa_{1.91}O₄:Cr_{0.09} | 1400 | Nb₂O₅ | 7.0 | Na₂CO₃ | 1.4 | 895 | 190 | 105 |
| Comparative Example 4 | MgGa_{1.91}O₄:Cr_{0.09} | 1500 | - | - | - | - | 885 | 185 | 100 |

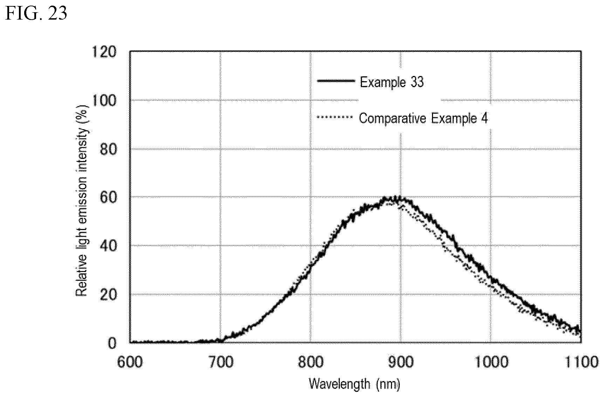

The oxide phosphor according to Example 33 exhibited a higher light emission intensity than that of the oxide phosphor according to Comparative Example 4, which had the same composition and had been heat-treated without using the first flux and the second flux. As shown in FIG. 23, although the light emission peak wavelengths of the light emission spectra of the oxide phosphor according to Example 33 and the oxide phosphor according to Comparative Example 4 were at approximately the same position, the light emission intensity at the light emission peak wavelength of the oxide phosphor according to Example 33 was higher than the light emission intensity at the light emission peak wavelength of the oxide phosphor according to Comparative Example 4.

### Example 34

A raw material mixture was provided using 3.22 g of MgO, 14.3 g of Ga₂O₃, 0.55 g of Cr₂O₃, and 0.18 g of NiO as raw materials (to obtain a target composition of MgGa_{1.91}O₄:Cr_{0.09},Ni_{0.03}). Subsequently, 1.27 g of Nb₂O₅ (7.0% by mass relative to 100% by mass of the raw material mixture) was provided as a first flux, and 0.25 g of Na₂CO₃ (1.4% by mass relative to 100% by mass of the raw material mixture) was provided as a second flux. The raw material mixture, the first flux, and the second flux were mixed using an agate mortar and an agate pestle for approximately 10 minutes to obtain a mixture.

The resulting mixture was placed in an alumina crucible and heat-treated at 1,400 °C for 8 hours in an air atmosphere (20% by volume of oxygen) with standard atmospheric pressure (0.101 MPa).

After the heat treatment, the resulting heat-treated product was pulverized to obtain an oxide phosphor according to Example 34 having the composition shown in Table 5 with the molar ratios of the target composition. The phosphor particles according to Example 34 had the composition represented by the formula (2), wherein t2 was 0 (t2 = 0), u2 was 1.0 (u2 = 1.0), v2 was 0 (v2 = 0), w2 was 4 (w2 = 4), x2 was 0.045 (x2 = 0.045), and y2 was 0.03 (y2 = 0.03). In Table 5, in the oxide phosphor according to Example 34, the molar ratio of Cr in 1 mol of the composition of the oxide phosphor was the product of 2 and x2, which was 0.09.

### Comparative Example 5

An oxide phosphor according to Comparative Example 5 was obtained in the same or similar manner as in Example 34, except that no flux was used, and the temperature of the heat treatment was set to 1,500 °C. The phosphor particles according to Comparative Example 5 had the composition represented by the formula (2), wherein t2 was 0 (t2 = 0), u2 was 1.0 (u2 = 1.0), v2 was 0 (v2 = 0), w2 was 4 (w2 = 4), x2 was 0.045 (x2 = 0.045), and y2 was 0.03 (y2 = 0.03). In Table 5, in the oxide phosphor according to Comparative Example 5, the molar ratio of Cr in 1 mol of the composition of the oxide phosphor was the product of 2 and x2, which was 0.09.

**Table 5**

| | Target composition | Heat treatment temperature (°C) | Flux | | | | Oxide fuorescent material | | |
|---|---|---|---|---|---|---|---|---|---|
| | | | First flux (other flux) | | Second flux | | Light emission peak wavelength | Full width at half maximum FWHM | Relative light emission intensity |
| | | | Oxide | %by mass | Second compound | %by mass | nm | nm | % |
| Example 34 | MgGa_{1.91}O₄:Cr_{0.09},N_{0.03} | 1400 | Nb₂O₅ | 7.0 | Na₂CO₃ | 1.4 | 1320 | 240 | 118 |
| Comparative Example 5 | MgGa_{1.91}O₄:Cr_{0.09},N_{0.03} | 1500 | - | - | - | - | 1320 | 245 | 100 |

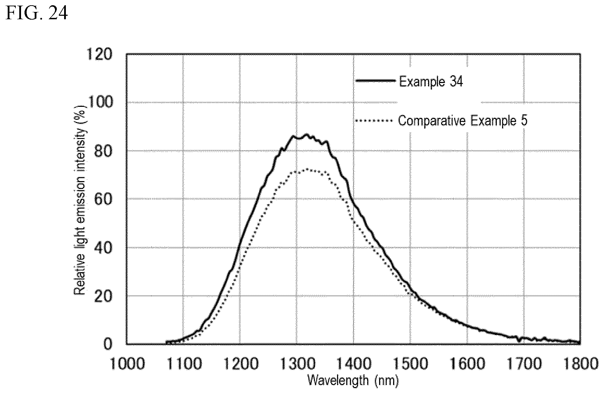

The oxide phosphor according to Example 34 had been heat-treated together with the first flux and/or the second flux, and thus had a larger particle diameter and a higher light emission intensity than those of the oxide phosphor according to Comparative Example 5, which had been heat-treated without using the flux. As shown in FIG. 24, although the light emission peak wavelengths in the light emission spectra of the oxide phosphor according to Example 34 and the oxide phosphor according to Comparative Example 5 were at approximately the same position, the light emission intensity at the light emission peak wavelength of the oxide phosphor according to Example 34 was higher than the light emission intensity at the light emission peak wavelength of the oxide phosphor according to Comparative Example 5.

### Example 35

A raw material mixture was provided using 1.48 g of Li₂CO₃, 18.1 g of Ga₂O₃, and 0.52 g of Cr₂O₃ as raw materials (to obtain a target composition of LiGa_{4.83}O₈:Cr_{0.17}). Subsequently, 1.41 g of Nb₂O₅ (7.0% by mass relative to 100% by mass of the raw material mixture) was provided as a first flux, and 0.28 g of Na₂CO₃ (1.4% by mass relative to 100% by mass of the raw material mixture) was provided as a second flux. The raw material mixture, the first flux, and the second flux were mixed using an agate mortar and an agate pestle for approximately 10 minutes to obtain a mixture. In 1 mol of the composition of the oxide phosphor, the molar ratio of an element without a numerical value is 1.0.

The resulting mixture was placed in an alumina crucible and heat-treated at 1,250 °C for 8 hours in an air atmosphere (20% by volume of oxygen) with standard atmospheric pressure (0.101 MPa).

After the heat treatment, the resulting heat-treated product was pulverized to obtain an oxide phosphor according to Example 35 having the composition shown in Table 6 with the molar ratios of the target composition. The phosphor particles according to Example 35 had the composition represented by the formula (3), wherein t3 was 0 (t3 = 0), u3 was 1.0 (u3 = 1.0), v3 was 0 (v3 = 0), w3 was 8 (w3 = 8), x3 was 0.034 (x3 = 0.034), y3 was 0 (y3 = 0), and z3 was 0 (z3 = 0). In Table 6, in the oxide phosphor according to Example 35, the molar ratio of Cr in 1 mol of the composition of the oxide phosphor was the product of 5 and x3, which was 0.17.

### Comparative Example 6

An oxide phosphor according to Comparative Example 6 was obtained in the same or similar manner as in Example 35, except that no flux was used, and the temperature of the heat treatment was set to 1,400 °C. The phosphor particles according to Comparative Example 6 had the composition represented by the formula (3), wherein t3 was 0 (t3 = 0), u3 was 1.0 (u3 = 1.0), v3 was 0 (v3 = 0), w3 was 8 (w3 = 8), x3 was 0.034 (x3 = 0.034), y3 was 0 (y3 = 0), and z3 was 0 (z3 = 0). In Table 6, in the oxide phosphor according to Comparative Example 6, the molar ratio of Cr in 1 mol of the composition of the oxide phosphor was the product of 5 and x3, which was 0.17.

**Table 6**

| | Target composition | Heat treatment temperature (°C) | Flux | | | | Oxide fluorescent material | | |
|---|---|---|---|---|---|---|---|---|---|
| | | | First flux (other flux) | | Second flux | | Light emission peak wavelength | Full width at half maximum FWHM | Relative light emission intensity |
| | | | Oxide | %by mass | Second compound | %by mass | Nm | nm | % |
| Example 35 | LiGa_{4.83}O₅:Cr_{0.17} | 1250 | Nb₂O₅ | 7.0 | Na₂CO₃ | 1.4 | 720 | 155 | 110 |
| Comparative Example 6 | LiGa_{4.83}O₅Cr_{0.17} | 1400 | - | - | - | - | 720 | 135 | 100 |

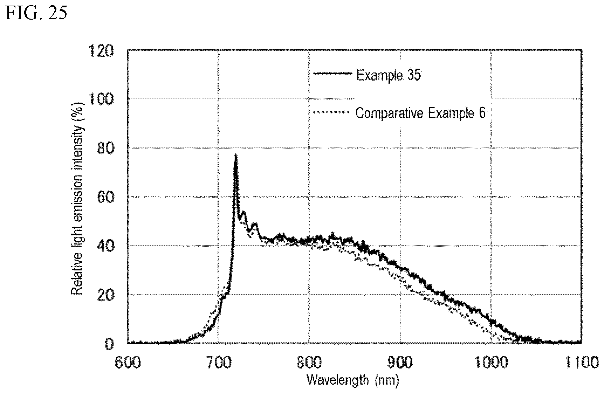

The oxide phosphor according to Example 35 had a higher light emission intensity than that of the oxide phosphor according to Comparative Example 6, which had the same composition as that in Example 35 and had been heat-treated without using the first flux and the second flux. As shown in FIG. 25, although the light emission peak wavelengths in the light emission spectra of the oxide phosphor according to Example 35 and the oxide phosphor according to Comparative Example 6 were at approximately the same position, the light emission intensity at the light emission peak wavelength of the oxide phosphor according to Example 35 was higher than the light emission intensity at the light emission peak wavelength of the oxide phosphor according to Comparative Example 6.

### Example 36

A raw material mixture was provided using 1.48 g of Li₂CO₃, 17.8 g of Ga₂O₃, 0.79 g of Cr₂O₃, and 0.07 g of NiO as raw materials (to obtain a target composition of LiGa_{4.74}O₈:Cr_{0.26},Ni_{0.022}). Subsequently, 2.80 g of Nb₂O₅ (14.0% by mass relative to 100% by mass of the raw material mixture) was provided as a first flux, and 0.56 g of Li₂CO₃ (2.8% by mass relative to 100% by mass of the raw material mixture) was provided as a second flux. The raw material mixture, the first flux, and the second flux were mixed using an agate mortar and an agate pestle for approximately 10 minutes to obtain a mixture. In 1 mol of the composition of the oxide phosphor, the molar ratio of an element without a numerical value is 1.0.

The resulting mixture was placed in an alumina crucible and heat-treated at 1,250 °C for 8 hours in an air atmosphere (20% by volume of oxygen) with standard atmospheric pressure (0.101 MPa).

After the heat treatment, the resulting heat-treated product was pulverized to obtain an oxide phosphor according to Example 36 having the composition shown in Table 7 with the molar ratios of the target composition. The phosphor particles according to Example 36 had the composition represented by the formula (3), wherein t3 was 0 (t3 = 0), u3 was 1.0 (u3 = 1.0), v3 was 0 (v3 = 0), w3 was 8 (w3 = 8), x3 was 0.052 (x3 = 0.052), y3 was 0.022 (y3 = 0.022), and z3 was 0 (z3 = 0). In Table 7, in the oxide phosphor according to Example 36, the molar ratio of Cr in 1 mol of the composition of the oxide phosphor was the product of 5 and x3, which was 0.26. The oxide phosphor according to Example 36 had a volume average particle diameter at 50% cumulative in the volume-based particle size distribution, as measured by the laser diffraction particle size distribution measurement method, of 17.6 µm.

### Comparative Example 7

An oxide phosphor according to Comparative Example 7 was obtained in the same or similar manner as in Example 36, except that no flux was used, and the temperature of the heat treatment was set to 1,400°C. The phosphor particles according to Comparative Example 7 had the composition represented by the formula (3), wherein t3 was 0 (t3 = 0), u3 was 1.0 (u3 = 1.0), v3 was 0 (v3 = 0), w3 was 8 (w3 = 8), x3 was 0.052 (x3 = 0.052), y3 was 0.022 (y3 = 0.022), and z3 was 0 (z3 = 0). In Table 7, in the oxide phosphor according to Comparative Example 7, the molar ratio of Cr in 1 mol of the composition of the oxide phosphor was the product of 5 and x3, which was 0.26. The oxide phosphor according to Comparative Example 7 had a volume average particle diameter at 50% cumulative in the volume-based particle size distribution, as measured by the laser diffraction particle size distribution measurement method, of 9.8 µm.

**Table 7**

| | Target composition | Heat treatment temperature (°C) | Flux | | | | Oxide fluorescent material | | |
|---|---|---|---|---|---|---|---|---|---|
| | | | First flux (other flux) | | Second flux | | Light emission peak wavelength | Full width at half maximum FWHM | Relative light emission intensity |
| | | | Oxide | %by mass | Second compound | %by mass | Nm | nm | % |
| Example 36 | LiGa_{4.74}O₈:Cr_{0.25},N_{0.022} | 1250 | Nb₂O₅ | 14.0 | Li₂CO₃ | 2.8 | 1275 | 235 | 120 |
| Comparative Example 7 | LiGa_{4.74}O₈:Cr_{0.25},N_{0.022} | 1400 | - | - | - | - | 1240 | 225 | 100 |

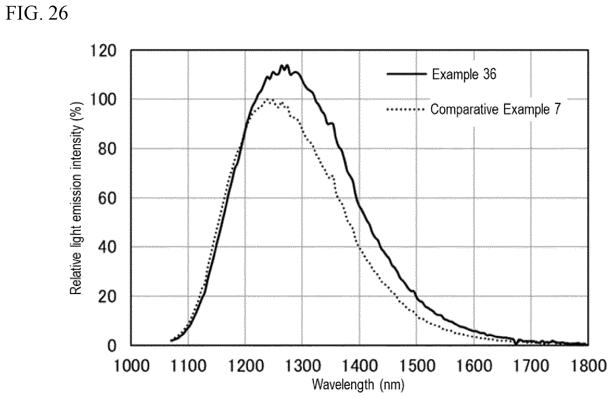

The oxide phosphor according to Example 36 had been heat-treated together with the first flux and/or the second flux, and thus had a larger particle diameter and exhibited a higher light emission intensity than those of the oxide phosphor according to Comparative Example 7, which was heat-treated without using the flux, even though the heat-treatment of Example 36 had been performed at a temperature of 1,250 °C, which was lower than that of Comparative Example 7. As shown in FIG. 26, although the light emission peak wavelengths in the light emission spectra of the oxide phosphor according to Example 36 and the oxide phosphor according to Comparative Example 7 were at approximately the same position, the light emission intensity at the light emission peak wavelength of the oxide phosphor according to Example 36 was higher than the light emission intensity at the light emission peak wavelength of the oxide phosphor according to Comparative Example 7.

The oxide phosphor according to Example 36 had a volume average particle diameter of 17.6 µm, which was larger than that of the oxide phosphor according to Comparative Example 7 heat-treated without using the first flux and/or the second flux.

Embodiments according to the present disclosure include the following oxide phosphor, light emitting device, and method for producing an oxide phosphor.
[Aspect 1] An oxide phosphor, comprising phosphor particles containing a host crystal containing Ga and oxygen and an activating element, and at least one first compound particle disposed on at least one of surfaces of the phosphor particles, the at least one first compound particle comprising an oxide particle comprising at least one first element selected from the group consisting of: Group 4 elements, Group 5 elements, Group 14 elements, and Group 15 elements.
[Aspect 2] The oxide phosphor according to Aspect 1, further comprising at least one second compound particle disposed on at least one of the surfaces of the phosphor particles, wherein the at least one second compound particle comprise at least one second element selected from the group consisting of alkali metal elements and alkaline earth metal elements.
[Aspect 3] The oxide phosphor according to Aspect 1 or 2, wherein an amount of the first element contained in the at least one first compound particle is 0.05% by mass or more and 80% by mass or less relative to a total amount of the oxide phosphor being 100% by mass.
[Aspect 4] The oxide phosphor according to any one of Aspects 1 to 3, wherein an amount of the second element contained in the at least one second compound particle is 0.01% by mass or more and 80% by mass or less relative to a total amount of the oxide phosphor being 100% by mass.
[Aspect 5] The oxide phosphor according to Aspect 2, wherein the amount of the first element is larger than the amount of the second element.
[Aspect 6] The oxide phosphor according to any one of Aspects 1 to 5, wherein a volume average particle diameter at 50% cumulative in a volume-based particle size distribution measured by a laser diffraction particle size distribution measurement method is 10 µm or more and 50 µm or less.
[Aspect 7] The oxide phosphor according to any one of Aspects 1 to 6, wherein the phosphor particles have a composition represented by the following formula (1), a composition represented by the following formula (2), or a composition represented by the following formula (3):

   (Ga₁₋ᵥ₁M¹ᵥ₁)₂O₃:Crₓ₁ (1),

   wherein M¹ represents at least one element selected from the group consisting of Al, In, and rare earth elements, and v1 and x1 satisfy 0 ≤ v1 ≤ 1.0 and 0.02 ≤ x1 ≤ 0.3;

   (Mg₁₋ₜ₂M²ₜ₂)ᵤ₂(Ga₁₋ᵥ₂₋ₓ₂M³ᵥ₂)₂O_{w2}:Cr₂ₓ₂,M⁴_{y2} (2),

   wherein M² represents at least one element selected from the group consisting of Ca, Sr, Ba, Ni, and Zn, M³ represents at least one element selected from the group consisting of B, Al, In, and Sc, M⁴ represents at least one element selected from the group consisting of Eu, Ce, Tb, Pr, Nd, Sm, Yb, Ho, Er, Tm, and Mn, t2, u2, v2, w2, x2, and y2 satisfy 0 ≤ t2 ≤ 0.8, 0.7 ≤ u2 ≤ 1.3, 0 ≤ v2 ≤ 0.8, 3.7 ≤ w2 ≤ 4.3, 0.01 < x2 ≤ 0.15, 0 ≤ y2 ≤ 0.2, and y2 < 2x2, and the "2x2" represents a product of 2 and the parameter x2; and

   (Li₁₋ₜ₃M⁵ₜ₃)ᵤ₃(Ga_{1-v3-x3-z3}M⁶ᵥ₃)₅O_{w3}:Cr₅ₓ₃,Ni_{y3},M⁷_{5z3} (3),

   wherein M⁵ represents at least one element selected from the group consisting of Na, K, Rb, and Cs, M⁶ represents at least one element selected from the group consisting of B, Al, In, and rare earth elements, M⁷ represents at least one element selected from the group consisting of Si, Ge, Sn, Ti, Zr, Hf, Bi, V, Nb, and Ta, t3, u3, v3, w3, x3, y3, and z3 satisfy 0 ≤ t3 ≤ 1.0, 0.7 ≤ u3 ≤ 1.6, 0 ≤ v3 < 1.0, 7.85 ≤ w3 ≤ 11.5, 0.01 ≤ x3 ≤ 0.24, 0 ≤ y3 ≤ 0.5, 0.25 < 5x3+y3 ≤ 1.2, y3 < 5x3, and 0 ≤ z3 ≤ 0.1, the "5x3" represents a product of 5 and the parameter x3, and the "5z3" represents a product of 5 and the parameter z3.
[Aspect 8] The oxide phosphor according to any one of Aspects 1 to 7, wherein the first element comprises at least one selected from the group consisting of Ti, Zr, Hf, V, Nb, Ta, Si, Ge, Sn, P, and Bi.
[Aspect 9] The oxide phosphor according to any one of Aspects 1 to 8, wherein the second element comprises at least one selected from the group consisting of Li, Na, K, Rb, Cs, Be, Mg, Ca, Sr, and Ba.
[Aspect 10] The oxide phosphor according to any one of: Aspects 1 to 6, Aspect 8 according to Aspect 1, and Aspect 9 according to Aspect 1, wherein the phosphor particles have a composition represented by the following formula (1-1), the oxide phosphor is configured to exhibit, in a powder X-ray diffraction pattern measured using CuKα rays, a first peak P1, which is a peak top having an intensity that is the highest within a range of a Bragg angle 20 of 34° to 36°, inclusive, a second peak P2, which is a peak top having an intensity lowest among intensities of peak tops within a range of a Bragg angle 2θ of 31° to 33°, inclusive, and a peak intensity ratio (P1/P2) of the first peak P1 to the second peak P2 of 5 or more and 100 or less:

   Ga₂O₃:Crₓ₁ (1-1),

   where x1 satisfies 0.02 ≤ x1 ≤ 0.3.
[Aspect 11] A light emitting device, comprising: the oxide phosphor according to any one of Aspects 1 to 10; and a light emitting element configured to emit light having a light emission peak wavelength of 365 nm or more and 650 nm or less, wherein the oxide phosphor is to be irradiated with the light emitted from the light emitting element.
[Aspect 12] A method for producing an oxide phosphor, comprising: providing a raw material mixture containing a compound containing Ga and a compound containing Cr that serves as an activating element; providing a first flux containing an oxide containing at least one first element selected from the group consisting of Group 4 elements, Group 5 elements, Group 14 elements, and Group 15 elements; mixing the raw material mixture and the first flux to obtain a mixture; and heat-treating the mixture to obtain an oxide phosphor, the oxide phosphor comprising phosphor particles, and at least one first compound particle containing the first element and disposed on at least one of surfaces of the phosphor particles.
[Aspect 13] A method for producing an oxide phosphor, comprising: providing a raw material mixture containing a compound containing Ga and a compound containing Cr that serves as an activating element; providing a first flux containing an oxide containing at least one first element selected from the group consisting of Group 4 elements, Group 5 elements, Group 14 elements, and Group 15 elements; providing a second flux containing a compound containing at least one second element selected from the group consisting of alkali metal elements and alkaline earth metal elements; mixing the raw material mixture, the first flux, and the second flux to obtain a mixture; and heat-treating the mixture to obtain an oxide phosphor, the oxide phosphor comprising: phosphor particles, at least one first compound particle containing the first element and disposed on at least one of surfaces of the phosphor particles, and at least one second compound particle containing the second element and disposed on at least one of surfaces of the phosphor particles.
[Aspect 14] The method for producing an oxide phosphor according to Aspect 12 or 13, wherein, in obtaining the mixture, the first flux is added in an amount of 0.05% by mass or more relative to an amount of the raw material mixture being 100% by mass.
[Aspect 15] The method for producing an oxide phosphor according to Aspect 13 or Aspect 14 according to Aspect 13, wherein, in obtaining the mixture, the second flux is added in an amount of 0.01% by mass or more relative to an amount of the raw material mixture being 100% by mass.
[Aspect 16] The method for producing an oxide phosphor according to any one of Aspect 13, and Aspects 14 and 15 according to Aspect 13, wherein, in obtaining the mixture, the amount (% by mass) of the first flux added relative to the amount of the raw material mixture being 100% by mass is 1.5 times or more the amount (% by mass) of the second flux added.
[Aspect 17] The method for producing an oxide phosphor according to any one of Aspects 12 to 16, wherein, in obtaining the oxide phosphor, a temperature of the heat treatment is 1,000 °C or higher and 1,700 °C or lower.
[Aspect 18] The method for producing an oxide phosphor according to any one of Aspects 12 to 17, wherein, in obtaining the oxide phosphor, the phosphor particles have a composition represented by the following formula (1), a composition represented by the following formula (2), or a composition represented by the following formula (3):

   (Ga₁₋ᵥ₁M¹ᵥ₁)₂O₃:Crₓ₁ (1),

   wherein M¹ represents at least one element selected from the group consisting of Al, In, and rare earth elements, and v1 and x1 satisfy 0 ≤ v1 ≤ 1.0 and 0.02 ≤ x1 ≤ 0.3;

   (Mg₁₋ₜ₂M²ₜ₂)ᵤ₂(Ga₁₋ᵥ₂₋ₓ₂M³ᵥ₂)₂O_{w2}:Cr₂ₓ₂,M⁴_{y2} (2),

   wherein M² represents at least one element selected from the group consisting of Ca, Sr, Ba, Ni, and Zn, M³ represents at least one element selected from the group consisting of B, Al, In, and Sc, M⁴ represents at least one element selected from the group consisting of Eu, Ce, Tb, Pr, Nd, Sm, Yb, Ho, Er, Tm, and Mn, t2, u2, v2, w2, x2, and y2 satisfy 0 ≤ t2 ≤ 0.8, 0.7 ≤ u2 ≤ 1.3, 0 ≤ v2 ≤ 0.8, 3.7 ≤ w2 ≤ 4.3, 0.01 < x2 ≤ 0.15, 0 ≤ y2 ≤ 0.2, and y2 < 2x2, and the "2x2" represents a product of 2 and the parameter x2; and

   (Li₁₋ₜ₃M⁵ₜ₃)ᵤ₃(Ga_{1-v3-x3-z3}M⁶ᵥ₃)₅O_{w3}:Cr₅ₓ₃,Ni_{y3},M⁷_{5z3} (3),

   wherein M⁵ represents at least one element selected from the group consisting of Na, K, Rb, and Cs, M⁶ represents at least one element selected from the group consisting of B, Al, In, and rare earth elements, M⁷ represents at least one element selected from the group consisting of Si, Ge, Sn, Ti, Zr, Hf, Bi, V, Nb, and Ta, t3, u3, v3, w3, x3, y3, and z3 satisfy 0 ≤ t3 ≤ 1.0, 0.7 ≤ u3 ≤ 1.6, 0 ≤ v3 < 1.0, 7.85 ≤ w3 ≤ 11.5, 0.01 ≤ x3 ≤ 0.24, 0 ≤ y3 ≤ 0.5, 0.25 < 5x3+y3 ≤ 1.2, y3 < 5x3, and 0 ≤ z3 ≤ 0.1, the "5x3" represents a product of 5 and the parameter x3, and the "5z3" represents a product of 5 and the parameter z3.
[Aspect 19] The method for producing an oxide phosphor according to any one of Aspects 12 to 18, wherein, in providing the first flux, the first element comprises at least one selected from the group consisting of Ti, Zr, Hf, V, Nb, Ta, Si, Ge, Sn, P, and Bi.
[Aspect 20] The method for producing an oxide phosphor according to any one of Aspect 13, and Aspects 14 to 19 according to Aspect 13, wherein, in providing the second flux, the second element comprises at least one selected from the group consisting of Li, Na, K, Rb, Cs, Be, Mg, Ca, Sr, and Ba.

The oxide phosphor according to the present disclosure can be used in light emitting devices for medical use to obtain information inside living bodies, light emitting devices to be mounted on small mobile devices such as smartphones and smartwatches to manage physical conditions, light emitting devices used in medical devices, light emitting devices for analyzers to non-destructively measure the internal information of agricultural products such as fruits, vegetables, rice, food, and pharmaceutical products, light emitting devices for plant cultivation to affect the photoreceptors of plants, and light emitting devices for reflection spectroscopic measuring devices used for measuring film thickness or the like.

## Claims

1. An oxide phosphor, comprising:
phosphor particles containing a host crystal containing Ga and oxygen and an activating element, and
at least one first compound particle disposed on at least one of surfaces of the phosphor particles, the at least one first compound particle comprising an oxide particle comprising at least one first element selected from the group consisting of Group 4 elements, Group 5 elements, Group 14 elements, and Group 15 elements.

2. The oxide phosphor according to claim 1, further comprising at least one second compound particle disposed on at least one of the surfaces of the phosphor particles,
wherein the at least one second compound particle comprise at least one second element selected from the group consisting of alkali metal elements and alkaline earth metal elements.

3. The oxide phosphor according to claim 1 or 2, wherein an amount of the at least one first element contained in the at least one first compound particle is 0.05% by mass or more and 80% by mass or less relative to a total amount of the oxide phosphor being 100% by mass.

4. The oxide phosphor according to claim 2, wherein an amount of the at least one second element contained in the at least one second compound particle is 0.01% by mass or more and 80% by mass or less relative to a total amount of the oxide phosphor being 100% by mass.

5. The oxide phosphor according to claim 2, wherein the amount of the at least one first element is larger than the amount of the at least one second element.

6. The oxide phosphor according to any one of claims 1 to 5, wherein a volume average particle diameter at 50% cumulative in a volume-based particle size distribution measured by a laser diffraction particle size distribution measurement method is 10 µm or more and 50 µm or less.

7. The oxide phosphor according to any one of claims 1 to 6, wherein the phosphor particles have a composition represented by the following formula (1), a composition represented by the following formula (2), or a composition represented by the following formula (3):
(Ga₁₋ᵥ₁M¹ᵥ₁)₂O₃:Crₓ₁ (1),
wherein M¹ represents at least one element selected from the group consisting of Al, In, and rare earth elements, and v1 and x1 satisfy 0 ≤ v1 ≤ 1.0 and 0.02 ≤ x1 ≤ 0.3;
(Mg₁₋ₜ₂M²ₜ₂)ᵤ₂(Ga₁₋ᵥ₂₋ₓ₂M³ᵥ₂)₂O_{w2}:Cr₂ₓ₂,M⁴_{y2} (2),
wherein M² represents at least one element selected from the group consisting of Ca, Sr, Ba, Ni, and Zn, M³ represents at least one element selected from the group consisting of B, Al, In, and Sc, M⁴ represents at least one element selected from the group consisting of Eu, Ce, Tb, Pr, Nd, Sm, Yb, Ho, Er, Tm, and Mn, t2, u2, v2, w2, x2, and y2 satisfy 0 ≤ t2 ≤ 0.8, 0.7 ≤ u2 ≤ 1.3, 0 ≤ v2 ≤ 0.8, 3.7 ≤ w2 ≤ 4.3, 0.01 < x2 ≤ 0.15, 0 ≤ y2 ≤ 0.2, and y2 < 2x2, and the "2x2" represents a product of 2 and the parameter x2; and
(Li₁₋ₜ₃M⁵ₜ₃)ᵤ₃(Ga_{1-v3-x3-z3}M⁶ᵥ₃)₅O_{w3}:Cr₅ₓ₃,Ni_{y3},M⁷_{5z3} (3),
wherein M⁵ represents at least one element selected from the group consisting of Na, K, Rb, and Cs, M⁶ represents at least one element selected from the group consisting of B, Al, In, and rare earth elements, M⁷ represents at least one element selected from the group consisting of Si, Ge, Sn, Ti, Zr, Hf, Bi, V, Nb, and Ta, t3, u3, v3, w3, x3, y3, and z3 satisfy 0 ≤ t3 ≤ 1.0, 0.7 ≤ u3 ≤ 1.6, 0 ≤ v3 < 1.0, 7.85 ≤ w3 ≤ 11.5, 0.01 ≤ x3 ≤ 0.24, 0 ≤ y3 ≤ 0.5, 0.25 < 5x3+y3 ≤ 1.2, y3 < 5x3, and 0 ≤ z3 ≤ 0.1, the "5x3" represents a product of 5 and the parameter x3, and the "5z3" represents a product of 5 and the parameter z3.

8. The oxide phosphor according to any one of claims 1 to 7, wherein the first element comprises at least one selected from the group consisting of Ti, Zr, Hf, V, Nb, Ta, Si, Ge, Sn, P, and Bi.

9. The oxide phosphor according to claim 2, wherein the second element comprises at least one selected from the group consisting of Li, Na, K, Rb, Cs, Be, Mg, Ca, Sr, and Ba.

10. The oxide phosphor according to any one of claims 1 to 6, 8 and 9, wherein
the phosphor particles have a composition represented by the following formula (1-1),
the oxide phosphor is configured to exhibit, in a powder X-ray diffraction pattern measured using CuKα rays, a first peak P1, which is a peak top having an intensity that is highest within a range of a Bragg angle 20 of 34° to 36°, inclusive, a second peak P2, which is a peak top having an intensity lowest among intensities of peak tops within a range of a Bragg angle 2θ of 31 ° to 33°, inclusive, and
a peak intensity ratio (P1/P2) of the first peak P1 to the second peak P2 of 5 or more and 100 or less:
Ga₂O₃:Crₓ₁ (1-1),
where x1 satisfies 0.02 ≤ x1 ≤ 0.3.

11. A light emitting device, comprising:
the oxide phosphor according to any one of claims 1 to 10; and
a light emitting element configured to emit light having a light emission peak wavelength of 365 nm or more and 650 nm or less,
wherein the oxide phosphor is to be irradiated with the light emitted from the light emitting element.

12. A method for producing an oxide phosphor, comprising:
providing a raw material mixture containing a compound containing Ga and a compound containing Cr that serves as an activating element;
providing a first flux containing an oxide containing at least one first element selected from the group consisting of Group 4 elements, Group 5 elements, Group 14 elements, and Group 15 elements;
mixing the raw material mixture and the first flux to obtain a mixture; and
heat-treating the mixture to obtain an oxide phosphor, the oxide phosphor comprising
phosphor particles, and
at least one first compound particle containing the first element and disposed on at least one of surfaces of the phosphor particles.

13. A method for producing an oxide phosphor, comprising:
providing a raw material mixture containing a compound containing Ga and a compound containing Cr that serves as an activating element;
providing a first flux containing an oxide containing at least one first element selected from the group consisting of Group 4 elements, Group 5 elements, Group 14 elements, and Group 15 elements;
providing a second flux containing a compound containing at least one second element selected from the group consisting of alkali metal elements and alkaline earth metal elements;
mixing the raw material mixture, the first flux, and the second flux to obtain a mixture; and
heat-treating the mixture to obtain an oxide phosphor, the oxide phosphor comprising:
phosphor particles,
at least one first compound particle containing the first element and disposed on at least one of surfaces of the phosphor particles, and
at least one second compound particle containing the second element and disposed on at least one of surfaces of the phosphor particles.

14. The method for producing an oxide phosphor according to claim 12 or 13, wherein, in obtaining the mixture, the first flux is added in an amount of 0.05% by mass or more relative to an amount of the raw material mixture being 100% by mass.

15. The method for producing an oxide phosphor according to claim 13, wherein, in obtaining the mixture, the second flux is added in an amount of 0.01 % by mass or more relative to an amount of the raw material mixture being 100% by mass.

16. The method for producing an oxide phosphor according to claim 13, wherein, in obtaining the mixture, an amount (% by mass) of the first flux added relative to the amount of the raw material mixture being 100% by mass is 1.5 times or more the amount (% by mass) of the second flux added.

17. The method for producing an oxide phosphor according to any one of claims 12 to 16, wherein, in obtaining the oxide phosphor, a temperature of a heat treatment is 1,000 °C or higher and 1,700 °C or lower.

18. The method for producing an oxide phosphor according to any one of claims 12 to 17, wherein, in obtaining the oxide phosphor, the phosphor particles have a composition represented by the following formula (1), a composition represented by the following formula (2), or a composition represented by the following formula (3):
(Ga₁₋ᵥ₁M¹ᵥ₁)O₃:Crₓ₁ (1),
wherein M¹ represents at least one element selected from the group consisting of Al, In, and rare earth elements, and v1 and x1 satisfy 0 ≤ v1 ≤ 1.0 and 0.02 ≤ x1 ≤ 0.3;
(Mg₁₋ₜ₂M²ₜ₂)ᵤ₂(Ga₁₋ᵥ₂₋ₓ₂M³ᵥ₂)₂O_{w2}:Cr₂ₓ₂,M⁴_{y2} (2),
wherein M² represents at least one element selected from the group consisting of Ca, Sr, Ba, Ni, and Zn, M³ represents at least one element selected from the group consisting of B, Al, In, and Sc, M⁴ represents at least one element selected from the group consisting of Eu, Ce, Tb, Pr, Nd, Sm, Yb, Ho, Er, Tm, and Mn, t2, u2, v2, w2, x2, and y2 satisfy 0 ≤ t2 ≤ 0.8, 0.7 ≤ u2 ≤ 1.3, 0 ≤ v2 ≤ 0.8, 3.7 ≤ w2 ≤ 4.3, 0.01 < x2 ≤ 0.15, 0 ≤ y2 ≤ 0.2, and y2 < 2x2, and the "2x2" represents a product of 2 and the parameter x2; and
(Li₁₋ₜ₃M⁵ₜ₃)ᵤ₃(Ga_{1-v3-x3-z3}M⁶ᵥ₃)₅O_{w3}:Cr₅ₓ₃,Ni_{y3}M⁷_{5z3} (3),
wherein M⁵ represents at least one element selected from the group consisting of Na, K, Rb, and Cs, M⁶ represents at least one element selected from the group consisting of B, Al, In, and rare earth elements, M⁷ represents at least one element selected from the group consisting of Si, Ge, Sn, Ti, Zr, Hf, Bi, V, Nb, and Ta, t3, u3, v3, w3, x3, y3, and z3 satisfy 0 ≤ t3 ≤ 1.0, 0.7 ≤ u3 ≤ 1.6, 0 ≤ v3 < 1.0, 7.85 ≤ w3 ≤ 11.5, 0.01 ≤ x3 ≤ 0.24, 0 ≤ y3 ≤ 0.5, 0.25 < 5x3+y3 ≤ 1.2, y3 < 5x3, and 0 ≤ z3 ≤ 0.1, the "5x3" represents a product of 5 and the parameter x3, and the "5z3" represents a product of 5 and the parameter z3.

19. The method for producing an oxide phosphor according to any one of claims 12 to 18, wherein, in providing the first flux, the first element comprises at least one selected from the group consisting of Ti, Zr, Hf, V, Nb, Ta, Si, Ge, Sn, P, and Bi.

20. The method for producing an oxide phosphor according to claim 13, wherein, in providing the second flux, the second element comprises at least one selected from the group
consisting of Li, Na, K, Rb, Cs, Be, Mg, Ca, Sr, and Ba.
